# EUROPEAN PATENT SPECIFICATION

(11) **EP 2 642 000 B1**
(45) Date of publication and mention of the grant of the patent: **02.01.2019**
(21) Application number: 13159771.8
(22) Date of filing: 18.03.2013
(51) Int. Cl.: C30B 9/06, C30B 29/40

(54) **Group 13 nitride crystal and group 13 nitride crystal substrate**
Gruppe 13-NItridkristall und Gruppe 13-Nitridkristallsubstrat
Cristal de nitrure du groupe 13 et substrat de cristaux de nitrure du groupe 13

(30) Priority: 19.03.2012 JP 2012062235
(43) Date of publication of application: 25.09.2013
(73) Proprietor: Ricoh Company, Limited, Tokyo 143-8555 (JP)
(72) Inventor: Hayashi, Masahiro, Ohta-ku, Tokyo 143-8555 (JP); Sarayama, Seiji, Ohta-ku, Tokyo 143-8555 (JP); Satoh, Takashi, Ohta-ku, Tokyo 143-8555 (JP); Kimura, Chiharu, Ohta-ku, Tokyo 143-8555 (JP); Miyoshi, Naoya, Ohta-ku, Tokyo 143-8555 (JP); Murakami, Akishige, Ohta-ku, Tokyo 143-8555 (JP); Wada, Junichi, Ohta-ku, Tokyo 143-8555 (JP)
(74) Representative: J A Kemp

(56) References cited:
- EP-A1- 1 754 811
- WO-A1-2005/121415
- WO-A1-2006/057463
- WO-A1-2009/149299
- WO-A1-2011/115072
- JP-A- 2008 094 704
- US-A1- 2008 008 855

## Description

### FIELD OF THE INVENTION

The present invention relates to a group 13 nitride crystal and a group 13 nitride crystal substrate.

### BACKGROUND OF THE INVENTION

Gallium nitride (GaN) based semiconductor materials are used for semiconductor devices, such as blue light-emitting diodes (LEDs), white LEDs, and laser diodes (LDs). White LEDs are used for backlights of mobile phone screens and liquid crystal displays and for lighting, for example. Blue LEDs are used for traffic lights and other illuminations, for example. Blue-violet LDs are used as light sources for Blu-ray discs. These days, most of GaN-based semiconductor devices used as ultraviolet, violet-blue-green light sources, are produced by performing crystal growth on a sapphire or silicon carbide (SiC) substrate with metal organic chemical vapor deposition (MOCVD) or molecular beam epitaxy (MBE), for example.

If sapphire or SiC is used as a substrate, crystal defects increase because of large difference in the coefficient of thermal expansion and in the lattice constant from a group 13 nitride. Such defects have negative effects on device characteristics, thereby making it difficult to extend the life of a light-emitting device or increasing operating power, for example. To address these problems, a GaN substrate made of the same material as that of the crystal growing on the substrate is most suitably used.

These days, a free-standing GaN substrate is manufactured by: growing GaN thickly on a dissimilar substrate, such as a sapphire substrate and a gallium arsenide (GaAs) substrate, by hydride vapor phase epitaxy (HVPE) using a growth method for reducing the dislocation density, such as epitaxial lateral overgrowth (ELO); and separating the GaN thick film from the dissimilar substrate. The dislocation density of the GaN substrate manufactured in this manner is reduced to approximately 10⁶ cm⁻². Furthermore, such a GaN substrate having a size of 2 inches is put into practical use and is mainly used for laser devices. Recently, to reduce cost of white LEDs and apply a substrate to electronic devices, designing of a substrate with a larger diameter of 4 inches or 6 inches is required.

However, warpage and a crack occurring because of difference in the coefficient of thermal expansion and in the lattice constant between the dissimilar substrate material and the GaN prevent designing of a large-diameter substrate. Furthermore, the dislocation density described above still remains. In addition, because a GaN substrate is manufactured by separating one GaN thick film from one dissimilar substrate and polishing the GaN thick film, it costs a lot to manufacture the GaN substrate.

By contrast, a flux method of dissolving nitrogen from a vapor phase into a mixed melt of an alkali metal and a group 13 metal to grow a GaN crystal has been researched and developed as one of methods for realizing a GaN substrate by liquid phase growth.

In the flux method, by heating a mixed melt containing an alkali metal, such as sodium (Na) and potassium (K), and a group 13 metal, such as gallium (Ga), to approximately 600 degrees C to 900 degrees C under an atmosphere at nitrogen pressure of equal to or lower than 10 MPa, nitrogen is dissolved from a vapor phase. Subsequently, by causing the nitrogen to react with the group 13 metal in the mixed melt, a group 13 nitride crystal is grown. The flux method enables crystal growth at a lower temperature and a lower pressure than other liquid phase growth. In addition, the crystal thus grown advantageously has a dislocation density of lower than 10⁶ cm⁻².

Chemistry of Materials Vol. 9 (1997) pp. 413-416 reports the fact that a GaN crystal was grown by placing sodium azide (NaN₃) and metal Ga serving as raw materials in a reaction container made of a stainless steel (inner dimension of the container: an inside diameter of 7.5 mm and a length of 100 mm) and sealing up the container under a nitrogen atmosphere, and maintaining the reaction container at a temperature from 600 degrees C to 800 degrees C for 24 hours to 100 hours.

Proc. 21st Century COE Joint Workshop on Bulk Nitrides IPAP Conf. Series 4 pp. 14-20 reports a dislocation and a tilt grain boundary generated when GaN is grown on a sapphire substrate by the MOCVD and the HVPE.

Japanese Patent Application Laid-open No. 2010-100449 discloses a method of growing a GaN crystal from a base substrate by the flux method. Japanese Patent No. 4588340 discloses a method of forming a mask film patterned on a base substrate and selectively growing GaN by the flux method. Japanese Patent Application Laid-open No. 2008-94704 discloses a method of using a needle crystal of aluminum nitride (AlN) as a seed crystal and growing a columnar crystal of GaN as a method for producing a large crystal of GaN. Japanese Patent Application Laid-open No. 2006-045047 discloses a method for producing a needle crystal of AlN serving as a seed crystal. Japanese Patent Application Laid-open No. 2010-254576 discloses a method for manufacturing a GaN substrate having a low dislocation by slicing a GaN crystal grown from a base substrate along a plane parallel to a growth direction.

EP 1754811 discloses a method of manufacturing a group III-nitride crystal wherein a seed crystal is prepared and a group III-nitride crystal is grown on the seed crystal by a liquid phase method; the method is such that a rate of crystal growth in a direction parallel to a main surface of the seed crystal is larger than a rate of crystal growth in a direction vertical to the main surface of the seed crystal with the result that most of the dislocations on the surface of the seed crystal propagate in a direction parallel to the main surface of the seed crystal, and hardly propagate in a direction vertical to the main surface of seed crystal, thus leading to a dislocation density of the surface parallel to the main surface of the seed crystal which is significantly reduced from the dislocation density of the main surface of the seed crystal.

US 2008/008855 discloses a crystalline composition comprising gallium and nitrogen, obtained by lateral growth from a suitably selected c-oriented seed crystal, and having an infrared absorption peak at about 3175cm⁻¹.

WO 2005/121415 discloses a method of preparing a bulk mono-crystalline gallium-containing nitride. The crystal is grown on a seed at least in the direction essentially perpendicular to the direction of the seed growth.

WO 2011/115072 discloses a method of manufacturing a gallium nitride crystal wherein the crystal has a length L of the c-axis of 9mm of more.

In the conventional technology, however, it is difficult to provide a high-quality bulk crystal because of influences of a threading dislocation of a c-plane and a basal plane dislocation.

Therefore, there is a need to provide a group 13 nitride crystal applicable to a high-quality group 13 nitride semiconductor substrate and a group 13 nitride crystal substrate.

### SUMMARY OF THE INVENTION

It is an object of the present invention to at least partially solve the problems in the conventional technology.

According to an embodiment, there is provided a group 13 nitride crystal having a hexagonal crystal structure containing a nitrogen atom and at least Ga, the group 13 nitride crystal comprising:
a basal plane dislocation in a plurality of directions, wherein
dislocation density of the basal plane dislocation is higher than dislocation density of a threading dislocation of a c-plane;
a first area (21A, 21B) provided to an inner side of a section intersecting a c-axis, the first area serving as a seed crystal; and
a second area (27) provided to an outside of the first area on the section and grown from the first area, wherein
the first area has
   a third area (29a) provided inside of the section and having a first peak including band-edge emission of GaN in an emission spectrum caused by electron beam excitation or ultraviolet light excitation and a second peak on the longer-wavelength side than the first peak, a peak intensity of the first peak being lower than a peak intensity of the second peak, and
   a fourth area (29b) provided in a manner covering at least a part of the outer circumference of the third area and having a first peak including band-edge emission of GaN in an emission spectrum cause by electron beam excitation or ultraviolet light excitation and a second peak on the longer-wavelength side than the first peak, a peak intensity of the first peak being higher than a peak intensity of the second peak, the fourth area having a thickness of equal to or larger than 100nm,
   wherein the boron concentration of the third area (29a) is higher than the boron concentration of the fourth area (29b).

According to another embodiment, there is provided a group 13 nitride crystal substrate including the group 13 nitride crystal according to the above embodiment.

The above and other objects, features, advantages and technical and industrial significance of this invention will be better understood by reading the following detailed description of presently preferred embodiments of the invention, when considered in connection with the accompanying drawings.

### BRIEF DESCRIPTION OF THE DRAWINGS

FIG. 1 is a schematic perspective view of a structure of a group 13 nitride crystal;
FIG. 2 is an exemplary sectional view of the group 13 nitride crystal along a section parallel to a c-axis and an a-axis;
FIG. 3 is an exemplary sectional view of the group 13 nitride crystal along a c-plane (0001);
FIG. 4 is a schematic perspective view of another structure of the group 13 nitride crystal;
FIG. 5 is a schematic perspective view of still another structure of the group 13 nitride crystal;
FIG. 6 is a sectional view of a seed crystal along the c-axis;
FIG. 7 is a schematic sectional view of a structure of the seed crystal;
FIG. 8 is a schematic sectional view of another structure of the seed crystal;
FIG. 9 is a schematic sectional view of still another structure of the seed crystal;
FIG. 10 is a graph of an example of an emission spectrum caused by electron beam excitation or ultraviolet light excitation;
FIG. 11 is a schematic sectional view of a crystal producing apparatus that produces a seed crystal;
FIG. 12 is a schematic sectional view of a crystal producing apparatus that produces a group 13 nitride crystal;
FIG. 13 is a view schematically illustrating a dislocation on a section parallel to the c-axis and the a-axis in the group 13 nitride crystal;
FIG. 14 is a schematic of processing performed on the group 13 nitride crystal;
FIG. 15 is a schematic of another processing performed on the group 13 nitride crystal;
FIG. 16A is a schematic of an example of a group 13 nitride crystal substrate;
FIG. 16B is a schematic of another example of the group 13 nitride crystal substrate;
FIG. 16C is a schematic of still another example of the group 13 nitride crystal substrate;
FIG. 17 is a schematic of a process in which the group 13 nitride crystal grows from the seed crystal;
FIG. 18 is a schematic of another process in which the group 13 nitride crystal grows from the seed crystal;
FIG. 19 is a schematic of still another process in which the group 13 nitride crystal grows from the seed crystal;
FIG. 20 is a schematic illustrating the relationship between the shape of the seed crystal and L/d;
FIG. 21 is a view of a mapping image of spectral intensity of photoluminescence from 360 nm to 370 nm;
FIG. 22 is a view of a mapping image of spectral intensity of photoluminescence from 500 nm to 800 nm;
FIG. 23 is a view schematically illustrating emission distribution of photoluminescence in an example; and
FIGS. 24A and 24B are views schematically illustrating a group 13 nitride crystal in a comparative example.

### DETAILED DESCRIPTION OF THE PREFERRED EMBODIMENTS

Exemplary embodiments of a group 13 nitride crystal and a group 13 nitride crystal substrate according to the present invention are described below with reference to the accompanying drawings. In the description below, the drawings only schematically illustrate shapes, sizes, and arrangement of components so as to understand the present invention and are not intended to limit the present invention. Furthermore, similar components illustrated in a plurality of drawings are represented by the same reference numerals, and a duplicated explanation thereof may be omitted.

A group 13 nitride crystal according to an embodiment of the present invention is a group 13 nitride crystal having a hexagonal crystal structure containing Ga and a nitrogen atom. The group 13 nitride crystal according to the present embodiment has a basal plane dislocation in a plurality of directions, and the dislocation density of the basal plane dislocation is higher than the dislocation density of a threading dislocation of a c-plane.

The basal plane dislocation (BPD) is a dislocation in a direction parallel to the c-plane (a plane perpendicular to a c-axis). In the group 13 nitride crystal according to the present embodiment, the BPD is present not in one direction but in a plurality of directions different from one another on a plane parallel to the c-plane. As a result, occurrence of warpage and distortion is suppressed compared with the case where a dislocation in a direction parallel to the c-plane is present in one direction.

Furthermore, in the group 13 nitride crystal according to the present embodiment, the dislocation density of the BPD is higher than the dislocation density of the threading dislocation of the c-plane. The threading dislocation of the c-plane is a dislocation in a direction threading through the c-plane. Thus, the dislocation in a direction threading through the c-plane is suppressed.

Therefore, it is possible to provide a group 13 nitride crystal of high quality.

Detailed description will be made below.

### [1] Group 13 nitride crystal

As described above, the group 13 nitride crystal according to the present embodiment is a group 13 nitride crystal having a hexagonal crystal structure containing Ga and a nitrogen atom.

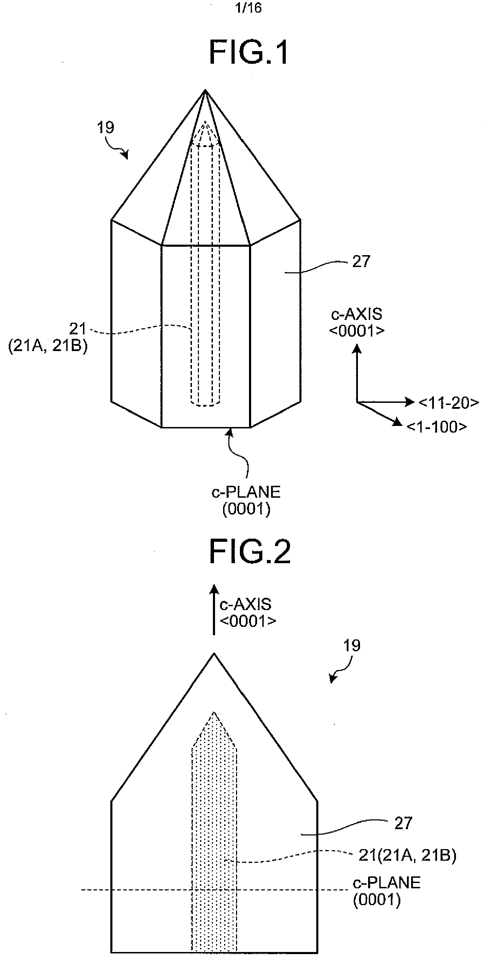

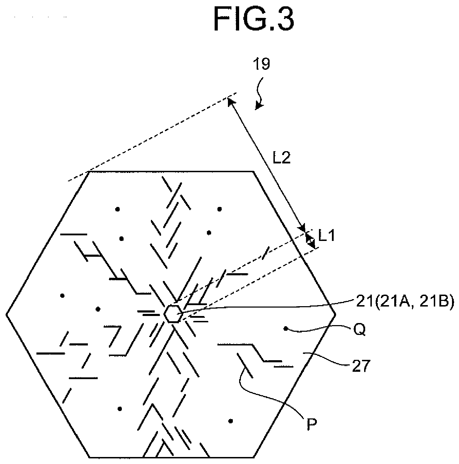

FIG. 1 to FIG. 3 illustrate an example of a group 13 nitride crystal 19 according to the present embodiment. In more detail, FIG. 1 is a schematic perspective view of an example of a structure of the group 13 nitride crystal 19 according to the present embodiment. FIG. 2 is a sectional view of the group 13 nitride crystal 19 along a section parallel to the c-axis and an a-axis. FIG. 3 is a sectional view of the group 13 nitride crystal 19 along a c-plane section (a section parallel to the c-plane).

As illustrated in FIG. 3, the c-plane section of the group 13 nitride crystal 19 is a hexagon. In the present embodiment, examples of the hexagon include a regular hexagon and hexagons other than the regular hexagon. The side surface of the group 13 nitride crystal 19 corresponding to a side of the hexagon is mainly formed of a {10-10} m-plane of the hexagonal crystal structure.

FIG. 1 illustrates the group 13 nitride crystal 19 in a columnar shape with a hexagonal pyramid, having a bottom surface on the c-plane (0001) and a central axis along the c-axis, provided on a hexagonal columnar crystal having a bottom surface on the c-plane (0001) and a central axis along the c-axis (that is, a <0001> direction). However, the group 13 nitride crystal 19 simply needs to have a hexagonal crystal structure and is not limited to a columnar crystal. The group 13 nitride crystal 19, for example, may have a shape with the c-plane formed at the apex of the hexagonal pyramid of the group 13 nitride crystal 19 illustrated in FIG. 1.

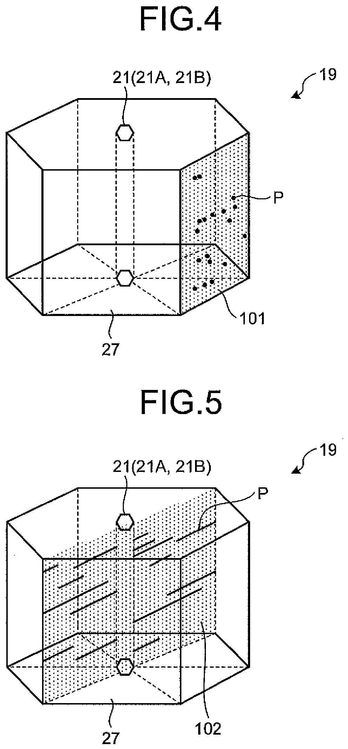

FIG. 4 and FIG. 5 are schematics of an example of the group 13 nitride crystal 19 in a shape with the c-plane formed at the apex of the hexagonal pyramid. As illustrated in FIG. 4 and FIG. 5, the group 13 nitride crystal 19 has a hexagonal crystal structure and may be in a shape with the c-plane formed at the apex of the hexagonal pyramid of the group 13 nitride crystal 19 illustrated in FIG. 1.

Referring back to FIG. 1, the group 13 nitride crystal 19 according to the present embodiment is a single crystal and includes a first area 21 and a second area 27. The first area 21 is an area provided to the inner side of the c-plane section in the group 13 nitride crystal 19. The first area 21 is a seed crystal, and the second area 27 is an area grown from the seed crystal. The first area 21 and the second area 27 have different crystallinities. The first area 21 and the second area 27 will be described later in detail. The group 13 nitride crystal 19 simply needs to be a crystal including the second area 27.

As described above, the group 13 nitride crystal 19 according to the present embodiment has a BPD in a plurality of directions different from one another. Furthermore, the dislocation density of the BPD is higher than the dislocation density of a dislocation in a direction threading through the c-plane in the group 13 nitride crystal 19.

In the group 13 nitride crystal 19, the dislocation density of the BPD simply needs to be higher than the dislocation density of the threading dislocation of the c-plane. More specifically, the dislocation density of the BPD is preferably equal to or more than 100 times higher than the dislocation density of the threading dislocation of the c-plane and more preferably equal to or more than 1000 times higher than the dislocation density of the threading dislocation of the c-plane.

In the group 13 nitride crystal 19, the dislocation density of the BPD and the dislocation density of the threading dislocation of the c-plane are measured by the following method.

For example, by etching the outermost surface of a measurement target surface, an etch pit is formed; subsequently, a micrograph of a structure of the measurement target surface thus etched is captured using an electron microscope; and the etch-pit density is calculated from the micrograph thus obtained.

Examples of the method for measuring the dislocation density include a method of measuring the measurement target surface by cathodoluminescence (CL).

The c-plane, the m-plane {10-10}, and an a-plane {11-20} are used as the measurement target surface, for example.

FIG. 3 is a schematic illustrating the case where the c-plane (c-plane section) of the group 13 nitride crystal 19 is used as the measurement target surface.

As illustrated in FIG. 3, the c-plane section of the group 13 nitride crystal 19 is etched as described above and is observed with the electron microscope or by CL. As a result, a plurality of dislocations are found. By counting a linear dislocation as a BPD P among the dislocations found on the c-plane section, the dislocation density of the BPD P is calculated. By contrast, by counting a dot dislocation as a threading dislocation Q among the dislocations found on the c-plane section, the dislocation density of the threading dislocation Q is calculated. In the case of CL, a dislocation is found as a dark dot or a dark line.

In respect to the dot dislocation, if the ratio of a major axis of a dot dislocation thus found to a minor axis thereof is equal to or larger than 1 and equal to or smaller than 1.5, the dislocation is counted as a "dot" dislocation in the present embodiment. Thus, the dot dislocation is not limited to a perfect circle, and an elliptically shaped dislocation is also counted as a dot dislocation. More specifically, a dislocation having a major axis of equal to or smaller than 0.5 µm in a sectional shape thus found is counted as the dot dislocation in the present embodiment.

By contrast, in respect to the linear dislocation, if the ratio of a major axis of a linear dislocation thus found to a minor axis thereof is equal to or larger than 4, the dislocation is counted as a "linear" dislocation in the present embodiment. More specifically, a dislocation having a major axis of larger than 2 µm in a sectional shape thus found is counted as the linear dislocation in the present embodiment.

FIG. 4 is a schematic illustrating the case where the side surface (m-plane {10-10}) in the hexagonal group 13 nitride crystal 19 is used as the measurement target surface.

As illustrated in FIG. 4, the m-plane {10-10} of the group 13 nitride crystal 19 is etched as described above and is observed with the electron microscope or by CL. As a result, a plurality of dislocations are found. By counting a dot dislocation as the BPD P among the dislocations found on the m-plane {10-10}, the dislocation density of the BPD P is calculated. A linear dislocation in a direction perpendicular to the c-axis is also counted as the BPD P. By contrast, among the dislocations found on the m-plane {10-10}, a linear dislocation extending in the c-axis direction can be counted as the threading dislocation Q.

The definitions of the dot dislocation and the linear dislocation are the same as those described above.

FIG. 5 is a schematic illustrating the case where an m-plane parallel to the a-axis and the c-axis in the hexagonal group 13 nitride crystal 19 is used as the measurement target surface. FIG. 5 illustrates a section parallel to the c-axis and passing through the first area 21, which is the seed crystal, in the group 13 nitride crystal 19.

As illustrated in FIG. 5, the m-plane {10-10} of the group 13 nitride crystal 19 is etched as described above and is observed with the electron microscope or by CL. As a result, a plurality of dislocations are found. Among the dislocations found on the m-plane {10-10} in FIG. 5, a linear dislocation extending in a direction parallel to the a-axis can be counted as the BPD P. By contrast, a linear dislocation extending in a direction parallel to the c-axis can be counted as the threading dislocation Q. The definitions of the dot dislocation and the linear dislocation are the same as those described above.

Referring back to FIG. 3, the BPDs P in the group 13 nitride crystal 19 according to the present embodiment include a dislocation extending in a direction from the first area 21 to the second area 27. In other words, as illustrated in FIG. 3, the BPD P is present on a plane parallel to the c-plane as a dislocation extending in a direction outward in the second area 27, which is an area grown from the seed crystal.

The dislocation density of the BPD in the group 13 nitride crystal 19 is higher than the grain boundary density on the c-plane.

The grain boundary is an interface between crystals and can be considered as an aggregate of dislocations. The dislocation density of the BPD in the group 13 nitride crystal 19 simply needs to be higher than the grain boundary density on the c-plane. More specifically, the dislocation density of the BPD in the group 13 nitride crystal 19 is preferably equal to or more than 10 times higher than the grain boundary density on the c-plane and more preferably equal to or more than 100 times higher than the grain boundary density on the c-plane.

The grain boundary density is measured by the following method.

The grain boundary density can be measured by a well-known crystal analysis method. By using the measurement target surface etched in the etching for measurement of the dislocation density, for example, the grain boundary density can be measured by an analysis method, such as X-ray diffraction, X-ray topography, simple light reflection, CL, and a micro-level analysis of an atomic image captured by a transmission electron microscope.

By comparing an image obtained by white X-ray topography using radiated light with an appearance of a crystal, the number of grain boundaries can be determined. If the appearance of the crystal and the external form of the image obtained by the topography are similar to each other, it is determined that a small number of grain boundaries are present. By contrast, if the external form of the image obtained by the topography is significantly distorted or only a part of the crystal is shown in the image, it is determined that a large number of grain boundaries are present.

The grain boundary density of a section intersecting the c-plane is preferably higher than the grain boundary density of the c-plane in the group 13 nitride crystal 19 according to the present embodiment.

The grain boundary density of the section intersecting the c-plane in the group 13 nitride crystal 19 is more preferably equal to or more than 10 times higher than the grain boundary density of the c-plane and particularly preferably equal to or more than 100 times higher than the grain boundary density of the c-plane.

The number of grain boundaries per 1 cm² on the c-plane of the group 13 nitride crystal 19 is preferably equal to or less than 1 and is particularly preferably 0.

The grain boundary and the grain boundary density may be measured by the method described above.

The first area 21 that is a seed crystal and the second area 27 that is a growth area where crystal has grown from the seed crystal in the group 13 nitride crystal 19 will now be described in detail.

The second area 27 is provided in a manner covering at least a part of the outer circumference of the first area 21 on the c-plane section in the group 13 nitride crystal 19. The second area 27 simply needs to be provided in a manner covering at least a part of the outer circumference of the first area 21 and may be provided in a manner covering the entire outer circumference of the first area 21. In the group 13 nitride crystal 19 illustrated in FIG. 3, the second area 27 is provided in a manner covering the entire outer circumference of the first area 21.

The thickness of the second area 27 on the c-plane section is larger than the maximum diameter of the first area 21. The thickness of the second area 27 is the maximum length, that is, the maximum thickness of the second area 27 in a direction from the center of the first area 21 to the outer edge of the group 13 nitride crystal 19 on the c-plane section. In the example of FIG. 3, the thickness of the second area 27 is represented by a length L2.

The maximum diameter of the first area 21 is the maximum value of the diameter of the first area 21 and is represented by a length L1 in the example of FIG. 3.

The relationship between the thickness of the second area 27 and the maximum diameter of the first area 21 on the c-plane section of the group 13 nitride crystal 19 according to the present embodiment is not particularly restricted as long as it satisfies the relationship described above. More specifically, the thickness of the second area 27 is preferably equal to or more than 5 times larger than the maximum diameter of the first area 21 and is more preferably equal to or more than 10 times larger than the maximum diameter of the first area 21.

The carrier concentration of the second area 27 is higher than the carrier concentration of the first area 21. In the group 13 nitride crystal 19 according to the present embodiment, the relationship between the carrier concentrations of the first area 21 and the second area 27 is not particularly restricted as long as it satisfies the relationship described above. More specifically, the carrier concentration of the second area 27 is preferably equal to or more than 5 times higher than the carrier concentration of the first area 21 and more preferably equal to or 10 times higher than the carrier concentration of the first area 21.

Furthermore, the relationship between the carrier concentrations of the first area 21 and the second area 27 is not particularly restricted as long as it satisfies the relationship described above. More specifically, the carrier concentration of the first area 21 is preferably equal to or lower than 2x10¹⁸/cm³ or equal to or lower than 8×10¹⁷/cm³. The carrier concentration of the second area 27 is preferably equal to or higher than 4x10¹⁸/cm³ or equal to or higher than 8×10¹⁸/cm³.

In the present embodiment, the carrier corresponds to an electron, and the carrier concentration corresponds to the electron carrier concentration.

The carrier concentrations of the first area 21 and the second area 27 are measured by the following measuring method.

The carrier concentrations of the first area 21 and the second area 27 are measured by converting the carrier density using Raman spectroscopy. To convert the carrier concentration, "Journal of the Spectroscopical Society of Japan 49 (2000) Characterization of GaN and Related Nitrides by Raman Scattering: Hiroshi Harima" is used. As a measuring device, a laser Raman spectroscopic device is used for the measurement.

The carrier concentrations of the first area 21 and the second area 27 are controlled so as to satisfy the relationship described above by controlling production conditions in a production method of the group 13 nitride crystal 19, which will be described later. Furthermore, the size of the first area 21 and the second area 27 (the thickness and the diameter) are also controlled so as to satisfy the relationship described above by controlling production conditions in the production method of the group 13 nitride crystal 19, which will be described later.

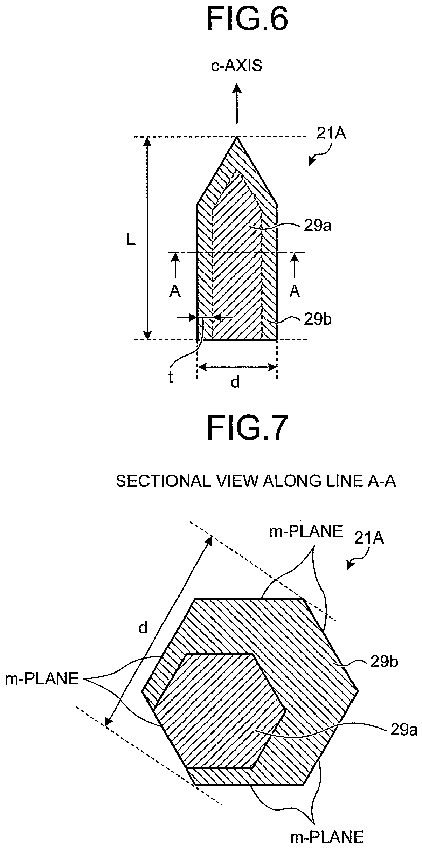

The first area 21 of the group 13 nitride crystal 19 according to the present embodiment may be formed of a plurality of areas. As illustrated in FIG. 6 to FIG. 8, for example, a first area 21A may be used instead of the first area 21.

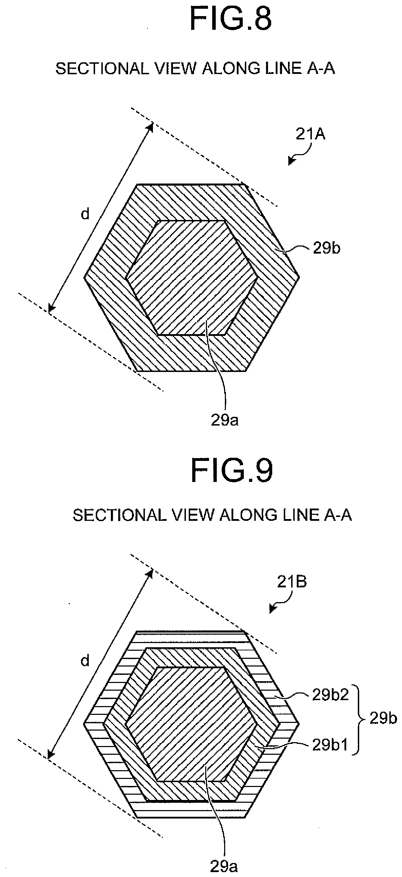

FIG. 6 to FIG. 8 illustrate an example of a crystal having a hexagonal crystal structure formed of the first area 21A. In more detail, FIG. 6 is a view of a section parallel to the c-axis and the a-axis in the hexagonal crystal formed of the first area 21A. FIG. 7 and FIG. 8 are sectional views of the c-plane section in the hexagonal crystal formed of the first area 21A.

A third area 29a is provided inside of the first area 21A on the c-plane section. Furthermore, a fourth area 29b is provided in a manner covering at least a part of the outer circumference of the third area 29a.

The fourth area 29b simply needs to be provided in a manner covering at least a part of the outer circumference of the third area 29a. Therefore, the fourth area 29b may be provided in a manner covering the entire outer circumference of the third area 29a (refer to FIG. 8). Alternatively, a part of the outer circumference of the third area 29a may have a portion to which the fourth area 29b is not provided (refer to FIG. 7).

Similarly to the example described above, the first area 21A simply needs to include the third area 29a and the fourth area 29b on at least one of sections intersecting the c-axis, and the section is not limited to the c-plane section strictly.

The thickness of the fourth area 29b is equal to or larger than 100 nm.

If a group 13 nitride crystal is grown by the flux method using a GaN crystal as a seed crystal, melt-back of the seed crystal may possibly occur. In terms of melt-back, it is known that the amount of dissolution (amount of melt-back) increases if the seed crystal is poor in quality, particularly, if an affected layer remains in the seed crystal.

To address this, the fourth area 29b that is a crystal layer of higher quality than that of the third area 29a is provided by a thickness of equal to or larger than 100 nm at the outer side of the crystal. Therefore, even if melt-back occurs in a process of growing the seed crystal, the fourth area 29b is likely to remain, thereby facilitating growth of the second area 27 of higher quality.

While the c-plane section of the group 13 nitride crystal 19 and the sections of the areas are shown as regular hexagons in FIG. 3, FIG. 7, FIG. 8, and other figures, these figures are given just as schematics, and each of the sections is not limited to a regular hexagon. The c-plane section of the group 13 nitride crystal 19 and the c-plane sections of the areas are each formed in a nearly hexagonal shape by the section of the group 13 nitride crystal 19 having a hexagonal crystal structure. If other structures are formed at the inside or the boundary of the sections in the process of crystal growth, the outline of each hexagon may possibly be deformed by the boundaries of the other structures.

Furthermore, the group 13 nitride crystal 19 is not necessarily formed only of the areas described above (the first area 21 or the first area 21A, and the second area 27). The group 13 nitride crystal 19 may further include other structures and other areas (e.g., the N-th area (N represents an integer equal to or more than 5 in the present embodiment)) having optical characteristics.

FIG. 9 is a view of an example of a crystal having a hexagonal crystal structure formed of a first area 21B. In more detail, FIG. 9 is a sectional view of the c-plane section in the hexagonal crystal formed of the first area 21B.

As illustrated in FIG. 9, the third area 29a is provided in the first area 21B. Furthermore, a fourth area 29b1 and a fourth area 29b2 may be provided in a manner covering at least a part of the outer circumference of the third area 29a.

### Properties of each area

Crystal properties of the first area 21 (the first area 21A and the first area 21B) and the second area 27 of the group 13 nitride crystal 19 will now be described.

### Light emission property

The peak intensity of a first peak including band-edge emission of GaN in an emission spectrum caused by electron beam excitation or ultraviolet light excitation in the third area 29a and the fourth area 29b on the c-plane section of the group 13 nitride crystal 19 according to the present embodiment and the peak intensity of a second peak on the longer-wavelength side than the first peak have the following relationship.

Specifically, the peak intensity of the first peak in the third area 29a is lower than the peak intensity of the second peak, and the peak intensity of the first peak in the fourth area 29b is higher than the peak intensity of the second peak.

The peak intensity of the first peak and the peak intensity of the second peak in the third area 29a and the fourth area 29b are not restricted as long as they satisfy the relationship described above. More specifically, the peak intensity of the first peak in the fourth area 29b is preferably higher than the peak intensity of the first peak in the third area 29a. Furthermore, the peak intensity of the second peak in the fourth area 29b is preferably lower than the peak intensity of the second peak in the third area 29a.

The first peak is light emission including band-edge emission (hereinafter, simply referred to as band-edge emission) of GaN in the measurement target area of the group 13 nitride crystal 19 and is a peak of an emission spectrum appearing in a wavelength range of approximately 364 nm in measurement at room temperature. The band-edge emission of GaN is light emission due to recombination of a hole at the upper edge of a valence band and an electron at the bottom of a conduction band in the group 13 nitride crystal 19 and is emission of light having energy (wavelength) equal to the band gap. In other words, the first peak is a peak caused by binding (a binding state) of nitrogen and gallium and a periodic structure of the crystal in the group 13 nitride crystal 19. The first peak may include the band-edge emission and emission from the vicinity of the band edge.

The second peak is at least one peak appearing on the longer-wavelength side than the first peak and is a peak including light emission caused by impurities and defects, for example.

More preferably, the second peak falls within a wavelength range from 450 nm to 650 nm in an emission spectrum caused by electron beam excitation or ultraviolet light excitation in measurement at room temperature.

Still more preferably, the second peak falls within a wavelength range from 590 nm to 650 nm in an emission spectrum caused by electron beam excitation or ultraviolet light excitation in measurement at room temperature.

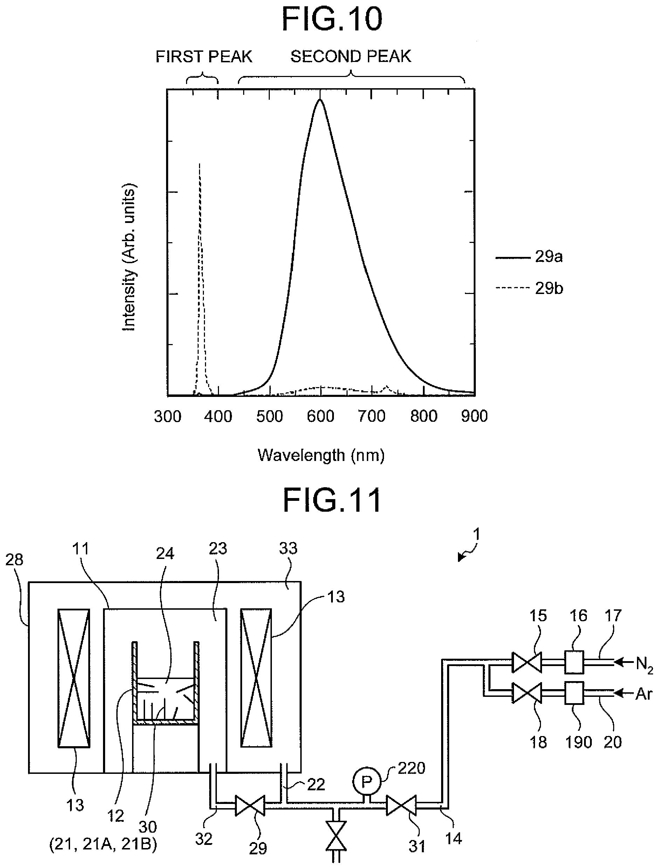

FIG. 10 is a graph of an example of an emission spectrum caused by electron beam excitation or ultraviolet light excitation in the third area 29a and the fourth area 29b.

In the emission spectrum in the third area 29a, the peak intensity of the second peak is higher than the peak intensity of the first peak. This indicates that the third area 29a contains a relatively large number of impurities and defects. By contrast, in the emission spectrum in the fourth area 29b, the peak intensity of the first peak is higher than the peak intensity of the second peak. This indicates that the fourth area 29b contains a relatively small number of impurities and defects and that the crystal of the fourth area 29b is excellent in quality.

Therefore, in the production method of the group 13 nitride crystal 19, which will be described later, if the crystal formed of the first area 21A is used as the seed crystal, it is possible to facilitate production of the group 13 nitride crystal 19 of higher quality compared with the case where the crystal formed of the first area 21 is used as the seed crystal. This is because crystal growth can be performed on the fourth area 29b having less impurities and defects by using the seed crystal formed of the first area 21A provided with the fourth area 29b having less impurities and defects on the outer side thereof.

Furthermore, in the production of a larger group 13 nitride crystal 19 by using the seed crystal formed of the first area 21A, the crystal growth can be performed from an area abutting on the fourth area 29b having less impurities, defects, and the like than the third area 29a. Thus, it is possible to obtain the second area 27 that is excellent in crystal quality and larger in size.

Examples of the impurities in the present embodiment include B, Al, O, Ti, Cu, Zn, Si, Na, K, Mg, Ca, W, C, Fe, Cr, Ni, and H.

In the fourth area 29b illustrated in FIG. 9, the emission intensity of the first peak in the fourth area 29b2 is lower than the emission intensity of the first peak in the fourth area 29b1, which is not illustrated.

### Boron concentration

The boron concentration of the third area 29a is higher than the boron concentration of the fourth area 29b. Specifically, for example, the boron concentration of the third area 29a is preferably equal to or higher than 4×10¹⁸ atms/cm³, and the boron concentration of the fourth area 29b positioned outside of the third area 29a is preferably lower than 4x10¹⁸ atms/cm³.

More preferably, the boron concentration of the third area 29a is equal to or higher than 6×10¹⁸ atms/cm³, and the boron concentration of the fourth area 29b is lower than 1×10¹⁸ atms/cm³.

In the production of the group 13 nitride crystal 19 by crystal growth from the seed crystal of the first area 21A provided with the fourth area 29b outside of the third area 29a, if the boron concentrations satisfy the relationship described above, it is possible to start the crystal growth mainly from the outer circumferential surface of the fourth area 29b with a low boron concentration and high quality. Therefore, even in the production of the group 13 nitride crystal 19 having a longer dimension in the c-axis direction using the seed crystal of the first area 21A elongated in the c-axis direction by a boron addition process, it is possible to produce the group 13 nitride crystal 19 of high quality.

### Production method

The production method of the group 13 nitride crystal 19 will now be described.

The group 13 nitride crystal 19 is produced by using the seed crystal of the first area 21, the seed crystal of the first area 21A, or the seed crystal of the first area 21B, and performing crystal growth from the seed crystal.

The seed crystal of the first area 21 and the seed crystals of the first area 21A and the first area 21B have a hexagonal crystal structure and are elongated in the c-axis direction. In the seed crystal of the first area 21 and the seed crystals of the first area 21A and the first area 21B, a section (c-plane section) perpendicular to the c-axis is a hexagon. The side surface of the seed crystal corresponding to a side of the hexagon is mainly formed of the m-plane of the hexagonal crystal structure.

The production method will be described in detail.

### [2] Crystal production method of a seed crystal

### Crystal producing apparatus

FIG. 11 is a schematic sectional view of a crystal producing apparatus 1 that produces a seed crystal 30 serving as the seed crystal of the first area 21 and the seed crystal of the first area 21A according to the present embodiment. In the description below, the seed crystal of the first area 21 and the seed crystals of the first area 21A and the first area 21B may be collectively referred to as the seed crystal 30.

As illustrated in FIG. 11, the crystal producing apparatus 1 has a dual structure: an inner container 11 is arranged in an outer pressure-resistant container 28 made of a stainless steel; and the inner container 11 houses a reaction container 12. The inner container 11 is attachable to and detachable from the outer pressure-resistant container 28.

The reaction container 12 is a container that contains therein a mixed melt 24 in which raw materials and additives are melted to provide the seed crystal 30. The configuration of the reaction container 12 will be described later.

Gas supply pipes 22 and 32 are connected to the outer pressure-resistant container 28 and the inner container 11, respectively. The gas supply pipes 22 and 32 supply a nitrogen (N₂) gas, which is a raw material of a group 13 nitride crystal, and a diluent gas for adjusting the total pressure to an internal space 33 of the outer pressure-resistant container 28 and an internal space 23 of the inner container 11, respectively. A gas supply pipe 14 is bifurcated into a N₂ supply pipe 17 and a diluent gas supply pipe 20, and these pipes can be separated from the gas supply pipe 14 by valves 15 and 18, respectively.

While an argon (Ar) gas, which is an inert gas, is preferably used as the diluent gas, the diluent gas is not limited thereto. Other inert gasses, such as helium (He), may be used as the diluent gas.

The N₂ gas is supplied from the N₂ supply pipe 17 connected, for example, to a gas cylinder of the N₂ gas. After the pressure of the N₂ gas is controlled by a pressure control device 16, the N₂ gas is supplied to the gas supply pipe 14 through the valve 15. By contrast, the diluent gas (e.g., an Ar gas) is supplied from the diluent gas supply pipe 20 connected, for example, to a gas cylinder of the diluent gas. After the pressure of the diluent gas is controlled by a pressure control device 190, the diluent gas is supplied to the gas supply pipe 14 through the valve 18. The N₂ gas and the diluent gas whose pressure is controlled in this manner are supplied to the gas supply pipe 14 and mixed.

The mixed gas of the N₂ gas and the diluent gas is supplied to the outer pressure-resistant container 28 and the inner container 11 through valves 31 and 29, respectively, from the gas supply pipe 14. The inner container 11 can be detached from the crystal producing apparatus 1 at the portion of the valve 29.

The gas supply pipe 14 is provided with a pressure gauge 220. Therefore, it is possible to control the pressure in the outer pressure-resistant container 28 and the inner container 11 while monitoring the total pressure in the outer pressure-resistant container 28 and the inner container 11 with the pressure gauge 220.

In the present embodiment, by controlling the pressure of the N₂ gas and the diluent gas in this manner with the valves 15 and 18 and the pressure control devices 16 and 190, respectively, the partial pressure of N₂ can be controlled. Furthermore, because the total pressure in the outer pressure-resistant container 28 and the inner container 11 can be controlled, evaporation of an alkali metal (e.g., sodium) in the reaction container 12 can be suppressed by setting the total pressure in the inner container 11 higher. In other words, it is possible to control the partial pressure of N₂ serving as a raw material for nitrogen affecting crystal growth conditions of GaN and the total pressure affecting suppression of evaporation of sodium separately.

As illustrated in FIG. 11, a heater 13 is arranged around the inner container 11 in the outer pressure-resistant container 28. The heater 13 can heat the inner container 11 and the reaction container 12, thereby enabling control of the temperature of the mixed melt 24.

In the present embodiment, the seed crystal 30 is produced by the flux method. An explanation will be made of the case where the seed crystal of the first area 21A (including the third area 29a and the fourth area 29b) or of the first area 21B is produced as the seed crystal 30.

To produce the seed crystal of the first area 21A or the first area 21B as the seed crystal 30, the following processes are performed: a boron dissolution process for dissolving boron into the mixed melt 24; a boron incorporation process for, during the growth of the GaN crystal, incorporating boron into the crystal; and a boron reduction process for lowering the boron concentration in the mixed melt 24 along with the crystal growth so as to perform crystal growth with different boron concentrations for the inner side of the crystal and the outer side of the crystal in the seed crystal 30.

To produce the seed crystal of the first area 21, a method may be employed in which the boron dissolution process and the boron incorporation process are performed and the boron reduction process is not performed. For this reason, an explanation will be made of the method for producing the seed crystal of the first area 21A as the seed crystal 30. The method for producing the seed crystal of the first area 21B is the same as that for producing the first area 21A.

In the boron dissolution process, boron is dissolved into the mixed melt 24 from boron nitride (BN) contained in the inner wall of the reaction container 12 or a BN member arranged in the reaction container 12. The dissolved boron is then incorporated into a growing crystal (the boron incorporation process). Subsequently, along with the crystal growth, the amount of boron incorporated into the crystal is gradually reduced (the boron reduction process).

In the boron reduction process, if the seed crystal 30 grows while growing the m-plane ({10-10} plane), the boron concentration in the outer side area can be made lower than the boron concentration in the inner side area on a section intersecting the c-axis. As a result, the concentration of boron that is an impurity and the dislocation density possibly caused by impurities in the crystal are reduced in the outer circumferential surface (six side surfaces of the hexagonal column) formed of the m-plane of the seed crystal 30. Thus, it is possible to form the outer circumferential surface of the seed crystal 30 with a crystal of excellent quality compared with the inner side area of the seed crystal 30.

In the method for producing the group 13 nitride crystal 19 (specifically, the second area 27) by performing crystal growth from the seed crystal 30, which will be described later in [3], the group 13 nitride crystal 19 grows mainly from the side surface (the outer circumferential surface formed of the m-plane) of the seed crystal 30 serving as a starting point of the crystal growth. Therefore, if the outer circumferential surface formed of the m-plane of the seed crystal 30 is excellent in quality as described above, the crystal growing therefrom is also excellent in quality. Thus, according to the present embodiment, it is possible to grow the seed crystal 30 that is large in size and excellent in quality and to provide the group 13 nitride crystal 19 (specifically, the second area 27) of high quality as a result of the crystal growth.

The boron dissolution process, the boron incorporation process, and the boron reduction process will now be described more specifically.

### (1) Method for causing the reaction container 12 to contain BN

In an example of the boron dissolution process, the reaction container 12 made of a sintered compact of BN (a BN sintered compact) may be used as the reaction container 12. While the reaction container 12 is being heated to a crystal growth temperature, boron is melted from the reaction container 12 and dissolved into the mixed melt 24 (the boron dissolution process). In the growth process of the seed crystal 30, the boron in the mixed melt 24 is incorporated into the seed crystal 30 (the boron incorporation process). Subsequently, along with the growth of the seed crystal 30, the boron in the mixed melt 24 is gradually reduced (the boron reduction process).

While the reaction container 12 made of a BN sintered compact is used in the description above, the structure of the reaction container 12 is not limited thereto. Preferably, a substance containing BN (e.g., a BN sintered compact) is used at least a part of the inner wall having contact with the mixed melt 24 in the reaction container 12. For the other parts of the reaction container 12, a nitride such as pyrolytic BN (P-BN), an oxide such as alumina and yttrium aluminum garnet (YAG), and a carbide such as SiC may be used, for example.

### (2) Method for arranging a member containing BN in the reaction container 12

In another example of the boron dissolution process, a member containing BN may be arranged in the reaction container 12. A member made of a BN sintered compact may be arranged in the reaction container 12, for example. Similarly to (1), the material of the reaction container 12 is not particularly restricted.

In this method, while the reaction container 12 is being heated to the crystal growth temperature described above, boron is gradually dissolved into the mixed melt 24 from the member arranged in the reaction container 12 (the boron dissolution process).

In the methods of (1) and (2), a crystal nucleus of a GaN crystal is likely to be formed on the surface of the member containing BN and having contact with the mixed melt 24. Therefore, if the crystal nucleus of GaN is formed on the surface of BN (that is, the inner wall surface or the surface of the member described above) and the surface is gradually covered with the crystal nucleus, the amount of boron dissolved into the mixed melt 24 from the BN thus covered is gradually reduced (the boron reduction process). Furthermore, along with the growth of the GaN crystal, the surface area of the crystal increases, whereby the density of incorporation of boron into the GaN crystal decreases (the boron reduction process).

While the explanation has been made of the case where boron is dissolved into the mixed melt 24 by using a substance containing boron in (1) and (2), the method for dissolving boron into the mixed melt 24 is not limited thereto. Other methods, such as addition of boron to the mixed melt 24, may be employed. Also for the method for reducing the boron concentration in the mixed melt 24, other methods may be employed. The crystal production method according to the present embodiment simply needs to include the boron dissolution process, the boron incorporation process, and the boron reduction process described above.

### Adjustment of raw material and the like and crystal growth conditions

Input of a raw material and the like to the reaction container 12 is performed by placing the inner container 11 in a glove box under an inert gas, such as an argon gas, atmosphere.

To produce the seed crystal 30 by the method of (1), the substance containing boron described in (1), a substance to be used as a flux, and the raw material are input to the reaction container 12 with the structure described in (1).

To produce the seed crystal 30 by the method of (2), the member containing boron described in (2), the substance to be used as a flux, and the raw material are input to the reaction container 12 with the structure described in (2).

While sodium or a sodium compound (e.g., sodium azide) is used as the substance to be used as a flux, the other alkali metals, such as lithium and potassium, and a compound of such an alkali metal may be used, for example. Alternatively, an alkaline earth metal, such as barium, strontium, and magnesium, and a compound of such an alkaline earth metal may be used. Furthermore, a plurality of types of alkali metals or alkaline earth metals may be used.

While the explanation has been made of the case where the reaction container 12 has a structure containing boron in the present embodiment, the structure is not limited thereto. The reaction container 12 may have a structure containing at least one of B, Al, O, Ti, Cu, Zn, and Si.

After setting the raw material and the like in this manner, the heater 13 is turned ON to heat the inner container 11 and the reaction container 12 inside thereof to the crystal growth temperature. As a result, the substance to be used as a flux and the raw material and the like are melted together to form the mixed melt 24. By bringing N₂ at the partial pressure described above into contact with the mixed melt 24 and dissolving the N₂ into the mixed melt 24, it is possible to supply the N₂ serving as the raw material of the seed crystal 30 to the mixed melt 24. Furthermore, boron is dissolved into the mixed melt 24 as described above (the boron dissolution process) (a mixed melt formation process).

On the inner wall of the reaction container 12, a crystal nucleus of the seed crystal 30 is formed from the raw material and the boron dissolved in the mixed melt 24. Subsequently, the raw material and the boron in the mixed melt 24 are supplied to the crystal nucleus to grow the crystal nucleus, whereby the seed crystal 30 in a needle shape is grown. In the crystal growth process of the seed crystal 30, the boron in the mixed melt 24 is incorporated into the crystal as described above (the boron addition process). As a result, the third area 29a having a higher boron concentration is likely to be formed on the inner side of the seed crystal 30, and the seed crystal 30 is likely to be elongated in the c-axis direction. As the boron to be incorporated into the crystal is reduced along with reduction in the boron concentration in the mixed melt 24 (the boron reduction process), the fourth area 29b having a lower boron concentration is likely to be formed on the outside of the third area 29a. As a result, the seed crystal 30 is less likely to be elongated in the c-axis direction and likely to grow in an m-axis direction.

The partial pressure of N₂ in the inner container 11 preferably falls within a range from 5 MPa to 10 Mpa.

The temperature (crystal growth temperature) of the mixed melt 24 preferably falls within a range from 800 degrees C to 900 degrees C.

More preferably, the ratio of the number of moles of an alkali metal (e.g., sodium) to the total number of moles of gallium and the alkali metal falls within a range from 75% to 90%, the crystal growth temperature of the mixed melt 24 falls within a range from 860 degrees C to 900 degrees C, and the partial pressure of N₂ falls within a range from 5 MPa to 8 Mpa.

Still more preferably, the molar ratio of gallium to the alkali metal is 0.25:0.75, the crystal growth temperature falls within a range from 860 degrees C to 870 degrees C, and the partial pressure of N₂ falls within a range from 7 MPa to 8 Mpa.

By performing the processes described above, the seed crystal of the first area 21A serving as the seed crystal 30 used for production of the group 13 nitride crystal 19 can be obtained. As described above, by performing the first process for growing the third area 29a of the GaN crystal containing boron without performing the second process, the seed crystal of the first area 21 can be obtained.

### [3] Production method of a group 13 nitride crystal

The group 13 nitride crystal 19 is produced by using the seed crystal 30 described in [2] and enlarging the cross-sectional area of the c-plane of the seed crystal 30 with the flux method.

### Crystal producing apparatus

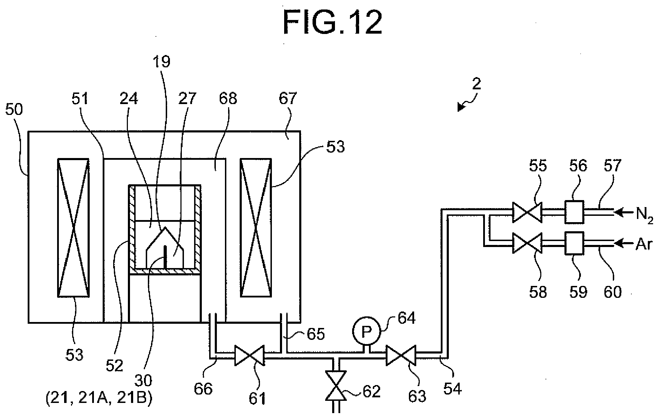

FIG. 12 is a schematic sectional view of an exemplary configuration of a crystal producing apparatus 2 used for growing the second area 27 from the seed crystal 30 to produce the group 13 nitride crystal 19. The crystal producing apparatus 2 has a dual structure: an inner container 51 is arranged in an outer pressure-resistant container 50 made of a stainless steel; and the inner container 51 houses a reaction container 52. The inner container 51 is attachable to and detachable from the outer pressure-resistant container 50. An explanation will be made of the case where the seed crystal of the first area 21A is used as the seed crystal 30.

The reaction container 52 is a container that contains therein the seed crystal 30 and the mixed melt 24 of an alkali metal and a substance containing at least a group 13 element to perform crystal growth of the second area 27 from the seed crystal 30 (note that growth of a bulk crystal from a seed crystal is referred to as seed growth (SG)).

The material of the reaction container 52 is not particularly restricted, and a nitride such as a BN sintered compact and P-BN, an oxide such as alumina and YAG, and a carbide such as SiC may be used as the material, for example. The inner wall surface of the reaction container 52, that is, the portion of the reaction container 52 having contact with the mixed melt 24 is preferably made of a material less likely to react with the mixed melt 24. In the production of the second area 27 as a GaN crystal, examples of the material that enables crystal growth of GaN include a nitride such as BN, P-BN, and aluminum nitride, an oxide such as alumina and YAG, and a stainless steel (SUS).

Gas supply pipes 65 and 66 are connected to the outer pressure-resistant container 50 and the inner container 51, respectively. The gas supply pipes 65 and 66 supply a N₂ gas, which is a raw material of the group 13 nitride crystal 19, and a diluent gas for adjusting the total pressure to an internal space 67 of the outer pressure-resistant container 50 and an internal space 68 of the inner container 51, respectively. A gas supply pipe 54 is bifurcated into a N₂ supply pipe 57 and a gas supply pipe 60, and these pipes can be separated from the gas supply pipe 54 by valves 55 and 58.

While an Ar gas, which is an inert gas, is preferably used as the diluent gas, the diluent gas is not limited thereto. Other inert gasses, such as He, may be used as the diluent gas.

The N₂ gas is supplied from the N₂ supply pipe 57 connected to a gas cylinder of the N₂ gas, for example. After the pressure of the N₂ gas is controlled by a pressure control device 56, the N₂ gas is supplied to the gas supply pipe 54 through the valve 55. By contrast, the gas for adjusting the total pressure (e.g., an Ar gas) is supplied from the gas supply pipe 60 for adjusting the total pressure connected to a gas cylinder of the gas for adjusting the total pressure, for example. After the pressure of the gas for adjusting the total pressure is controlled by a pressure control device 59, the gas for adjusting the total pressure is supplied to the gas supply pipe 54 through the valve 58. The N₂ gas and the gas for adjusting the total pressure whose pressure is controlled in this manner are supplied to the gas supply pipe 54 and mixed.

The mixed gas of the N₂ gas and the diluent gas is supplied to the outer pressure-resistant container 50 and the inner container 51 through a valve 63 and the gas supply pipe 65, and a valve 61 and the gas supply pipe 66, respectively, from the gas supply pipe 54. The inner container 51 can be detached from the crystal producing apparatus 2 at the portion of the valve 61. The gas supply pipe 65 is connected to the outside via a valve 62.

The gas supply pipe 54 is provided with a pressure gauge 64. Therefore, it is possible to control the pressure in the outer pressure-resistant container 50 and the inner container 51 while monitoring the total pressure in the outer pressure-resistant container 50 and the inner container 51 with the pressure gauge 64.

In the present embodiment, by adjusting the pressure of the N₂ gas and the diluent gas in this manner with the valves 55 and 58 and the pressure control devices 56 and 59, respectively, the partial pressure of N₂ can be controlled. Furthermore, because the total pressure in the outer pressure-resistant container 50 and the inner container 51 can be controlled, evaporation of an alkali metal (e.g., sodium) in the reaction container 52 can be suppressed by setting the total pressure in the inner container 51 higher. In other words, it is possible to control the partial pressure of N₂ serving as a raw material for nitrogen affecting crystal growth conditions of GaN and the total pressure affecting suppression of evaporation of sodium separately.

As illustrated in FIG. 12, a heater 53 is arranged around the inner container 51 in the outer pressure-resistant container 50. The heater 53 can heat the inner container 51 and the reaction container 52, thereby controlling the temperature of the mixed melt 24.

### Adjustment of raw material and the like and crystal growth conditions

Input of a raw material including the seed crystal 30, Ga, Na, an additive such as C, and a dopant such as Ge, for example, to the reaction container 52 is performed by placing the inner container 51 in a glove box under an inert gas, such as an argon gas, atmosphere. This can be done with the reaction container 52 placed in the inner container 51.

The seed crystal 30 described in [2] is arranged in the reaction container 52. Furthermore, a substance containing at least a group 13 element (e.g., gallium) and a substance to be used as a flux are input to the reaction container 52.

While sodium or a sodium compound (e.g., sodium azide)is used as the substance to be used as a flux, the other alkali metals, such as lithium and potassium, and a compound of such an alkali metal may be used, for example. Alternatively, an alkaline earth metal, such as barium, strontium, and magnesium, and a compound of such an alkaline earth metal may be used. Furthermore, a plurality of types of alkali metals or alkaline earth metals may be used.

While the molar ratio between the substance containing a group 13 element and the alkali metal is not particularly restricted, the molar ratio of the alkali metal to the total number of moles of the group 13 element and the alkali metal is preferably set to 40% to 90%.

After setting the raw material and the like in this manner, the heater 53 is turned ON to heat the inner container 51 and the reaction container 52 inside thereof to the crystal growth temperature. As a result, the substance containing a group 13 element serving as the raw material, the alkali metal, the additives and the like are melted together to form the mixed melt 24. By bringing N₂ at the partial pressure described above into contact with the mixed melt 24 and dissolving the N₂ into the mixed melt 24, it is possible to supply the N₂ serving as the raw material of the group 13 nitride crystal 19 to the mixed melt 24 (the mixed melt formation process).

Subsequently, the raw material dissolved in the mixed melt 24 is supplied to the outer circumferential surface of the seed crystal 30, whereby the second area 27 is grown from the outer circumferential surface of the seed crystal 30 with the raw material (the crystal growth process).

As described above, by growing the second area 27 from the outer circumferential surface of the seed crystal 30, it is possible to produce the group 13 nitride crystal 19 including the seed crystal 30.

Preferably, the partial pressure of the N₂ gas in the internal space 68 of the inner container 51 and the internal space 67 of the outer pressure-resistant container 50 is at least equal to or higher than 0.1 MPa. More preferably, the partial pressure of the N₂ gas in the internal space 68 of the inner container 51 and the internal space 67 of the outer pressure-resistant container 50 falls within a range from 2 MPa to 5 MPa.

Preferably, the temperature (crystal growth temperature) of the mixed melt 24 is at least equal to or higher than 700 degrees C. More preferably, the crystal growth temperature falls within a range from 850 degrees C to 900 degrees C.

The conditions of the single crystal growth process can be selected appropriately depending on the group 13 nitride crystal 19 to be produced.

The seed crystal of the first area 21 and the seed crystal of the first area 21A obtained by production of the seed crystal 30 are produced mainly by being grown in the c-axis direction. By contrast, the group 13 nitride crystal 19 produced by the crystal growth of the second area 27 from the seed crystal 30 is produced mainly by being grown in a direction perpendicular to the c-axis. Thus, the crystal growth direction of the first area 21 (or the first area 21A) is different from that of the second area 27. Because difference in the crystal growth direction leads to difference in the way of incorporating impurities, the first area 21 (or the first area 21A) and the second area 27 are different in the way of incorporating impurities. Therefore, the second area 27 obtained by the crystal growth in a direction perpendicular to the c-axis with the production method described above has a higher carrier concentration than the first area 21 (or the first area 21A) obtained by the crystal growth in the c-axis direction.

Furthermore, because the crystal of the first area 21 or the first area 21A is used as the seed crystal, the thickness of the second area 27 becomes larger than the maximum diameter of the first area 21 or the first area 21A on the c-plane section in the group 13 nitride crystal 19 thus produced, and the second area 27 is formed as a large area. Therefore, by using the second area 27, it is possible to provide the group 13 nitride crystal 19 that is excellent in quality and suitably applicable to a low-resistance conductive device, for example.

Examples of the conductive device include a semiconductor laser and a light-emitting diode.

Furthermore, if the group 13 nitride crystal 19 is produced by growing the second area 27 from the seed crystal 30 using the production method described above, the dislocation density of the second area 27 grown mainly from the outer circumferential surface formed of the m-plane of the seed crystal 30 is affected by the quality of the outer circumferential surface formed of the seed crystal 30.

As described in [2], if the seed crystal of the first area 21A is used as the seed crystal 30, the outer circumferential surface formed of the m-plane of the seed crystal 30 has a low dislocation density and high quality. Thus, by growing the second area 27 using the seed crystal 30, dislocations propagated from the seed crystal 30 to the second area 27 can be reduced. As a result, it is possible to keep the dislocation density of the group 13 nitride crystal 19 thus produced, more specifically, the dislocation density of the second area 27 lower. This makes it possible to facilitate production of the group 13 nitride crystal 19 that is large in size and excellent in quality.

In the present embodiment, the group 13 nitride crystal 19 produced by the production method described above grows in the m-axis direction (that is, a direction in which the c-plane section of the hexagon becomes larger) from the m-plane serving as the outer circumferential surface of the seed crystal 30 (the first area 21, the first area 21A, or the first area 21B). Therefore, the group 13 nitride crystal 19 showing the dislocation described above can be obtained.

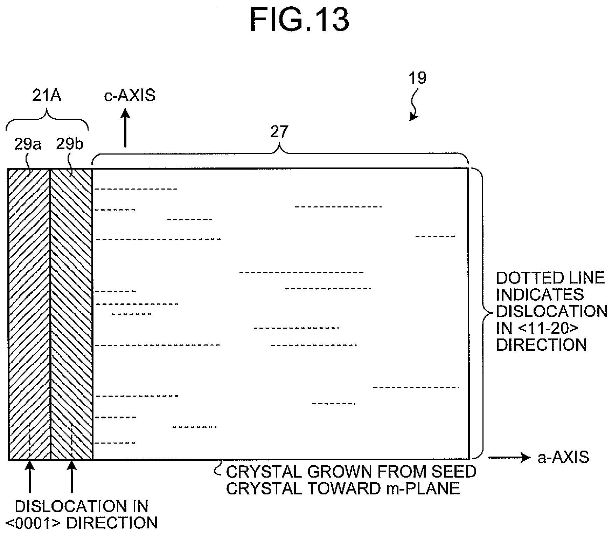

FIG. 13 is a view schematically illustrating a dislocation on a section parallel to the c-axis and the a-axis in the group 13 nitride crystal 19. FIG. 13 is an enlarged view of a portion on the right side of the first area 21A in the section parallel to the c-axis and the a-axis in the group 13 nitride crystal 19.

Typically, even if crystal growth is performed by any one of the flux method, the HVPE, and other methods, not a few dislocations occur in the group 13 nitride crystal 19. Furthermore, if a dislocation (a line defect or a point defect) is present on the outer circumferential surface of the first area 21A or the first area 21 (not illustrated in FIG. 13), the dislocation may possibly be propagated to the second area 27 when the second area 27 is grown form the outer circumferential surface of the seed crystal of the areas. It is considered that the dislocation is caused by difference in the coefficient of thermal expansion and in the lattice constant between the seed crystal and the second area 27 grown from the seed crystal and defects such as a strain and a crack of the crystal on the surface of the seed crystal, for example.

By contrast, in the present embodiment, the second area 27 is grown from the seed crystal of the first area 21A, that is, the fourth area 29b. Therefore, it is possible to facilitate reduction in the dislocation density of the second area 27 in the group 13 nitride crystal 19.

Typically, a dislocation (a line defect) extending parallel to the crystal growth direction continues to extend without vanishing during the crystal growth. By contrast, a line defect extending in a direction not parallel to the crystal growth direction frequently vanishes during the crystal growth. The group 13 nitride crystal 19 grows in the m-axis direction (that is, a direction in which the c-plane section of the hexagon becomes larger) from the m-plane serving as the outer circumferential surface of the seed crystal 30. Therefore, the number of dislocations occurring from the growth interface of the seed crystal is larger in a <11-20> direction parallel to the crystal growth direction and smaller in a <11-23> direction not parallel to the crystal growth direction.

Thus, in the group 13 nitride crystal 19 according to the present embodiment, the number of threading dislocations threading through the c-plane is smaller than the number of BPDs, which are dislocations parallel to the c-plane. The fact that the number of BPDs is larger than the number of threading dislocations indicates that the group 13 nitride crystal 19 is produced by being grown in a direction in which the c-plane section becomes larger.

As described above, the group 13 nitride crystal 19 according to the present embodiment is produced by being grown from the seed crystal 30 in a direction in which the hexagon of the c-plane section becomes larger. Therefore, the BPDs of the group 13 nitride crystal 19 thus produced include dislocations in directions parallel to the c-plane and different from one another (refer to FIG. 13).

If a group 13 crystal substrate is manufactured by using a group 13 nitride crystal in which the BPD, which is a dislocation in a direction along the c-plane, extends in one direction alone, the group 13 crystal substrate has large distortion and warpage. By contrast, in the group 13 nitride crystal 19 according to the present embodiment, the BPD extends not in one direction but in a plurality of directions. Therefore, the group 13 nitride crystal 19 according to the present embodiment is applicable to manufacturing of a group 13 crystal substrate in which distortion and warpage are suppressed.

Furthermore, the group 13 nitride crystal 19 produced by the production method described above is produced by being grown in a direction in which the c-plane section becomes larger. Therefore, the group 13 nitride crystal 19 according to the present embodiment can suppress generation of a grain boundary in a direction not parallel to the c-plane.

In the group 13 nitride crystal 19, no grain boundary is present on the c-plane of the second area 27 that is an area grown from the seed crystal 30 in the m-axis direction. However, a grain boundary may possibly be present between the first area 21 (the first area 21A or the first area 21B) serving as the seed crystal 30 and the second area 27.

As described above, the group 13 nitride crystal 19 according to the present embodiment has the BPD extending in directions different from one another. In the group 13 nitride crystal 19, the dislocation density of the BPD is preferably higher than the grain boundary density on the c-plane as described above. Furthermore, in the group 13 nitride crystal 19, the grain boundary density of a section intersecting the c-plane is preferably higher than the grain boundary density on the c-plane. Moreover, in the group 13 nitride crystal 19, the number of grain boundaries per 1 cm² on the c-plane is preferably equal to or less than 1.

Therefore, if a group 13 nitride crystal substrate having the principal surface formed of the c-plane is manufactured from the group 13 nitride crystal 19, the group 13 nitride crystal substrate can be of high quality.

In the crystal production method according to the present embodiment, the same material (e.g., GaN) may be used for the seed crystal 30 and the second area 27 grown from the seed crystal 30. In this case, unlike the case where a seed crystal made of a dissimilar material, such as aluminum nitride (AlN), is used, the lattice constants and the coefficients of thermal expansion of the seed crystal 30 and the second area 27 can agree with each other. As a result, it is possible to suppress occurrence of a dislocation due to lattice mismatch and difference in the coefficient of thermal expansion.

Furthermore, because the seed crystal 30 and the second area 27 are produced by the same crystal growth method (flux method), the agreement of the lattice constants and the coefficients of thermal expansion therebetween can be improved compared with the case where the seed crystal 30 and the second area 27 are produced by methods different from each other. As a result, it is possible to facilitate suppression of occurrence of a dislocation.

By performing the processes described above, it is possible to produce the group 13 nitride crystal 19 in practical size and of high quality.

While the explanation has been made of the crystal production method using the flux method, the crystal production method is not particularly restricted. The crystal growth may be performed by vapor phase epitaxy, such as the HVPE, or a liquid phase method other than the flux method. In terms of production of the group 13 nitride crystal 19 of high quality, the flux method is preferably used. Specifically, production of the group 13 nitride crystal 19 by the flux method enables growth of the second area 27 of higher quality. Therefore, it is possible to obtain the group 13 nitride crystal 19 of higher quality.

The position of the first area 21 or the first area 21A, which is an area used as the seed crystal, in the group 13 nitride crystal 19 produced by the production method described in [3] simply needs to be inside of the group 13 nitride crystal 19. The position may be a position threading through the center of the c-plane section of the group 13 nitride crystal 19 along the c-axis direction or a position deviated from the position threading through the center along the c-axis direction.

While the explanation has been made of the case where the group 13 nitride crystal 19 is a needle crystal obtained by providing, on a hexagonal columnar crystal, a hexagonal pyramid whose bottom surface is the upper surface of the hexagonal column in the present embodiment, the present invention is not limited to this shape. The group 13 nitride crystal 19 may have a hexagonal pyramid shape with no m-plane provided, for example.

### [4] Group 13 nitride crystal substrate

A group 13 nitride crystal substrate according to the present embodiment is obtained by processing the group 13 nitride crystal 19.

Based on a processing direction (a cutting direction) of the group 13 nitride crystal 19, the group 13 nitride crystal substrate having the principal surface formed of an arbitrary crystal plane, such as the c-plane, the m-plane, the a-plane, a {10-11} plane, and a {11-23} plane can be obtained.

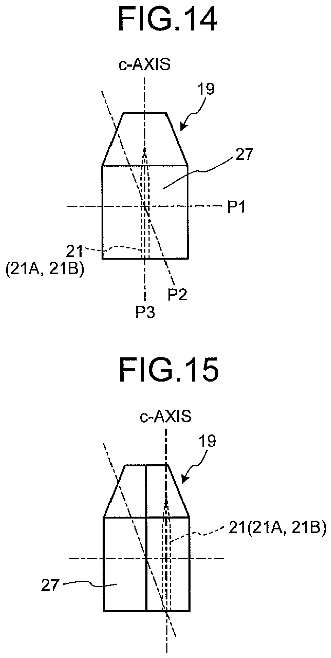

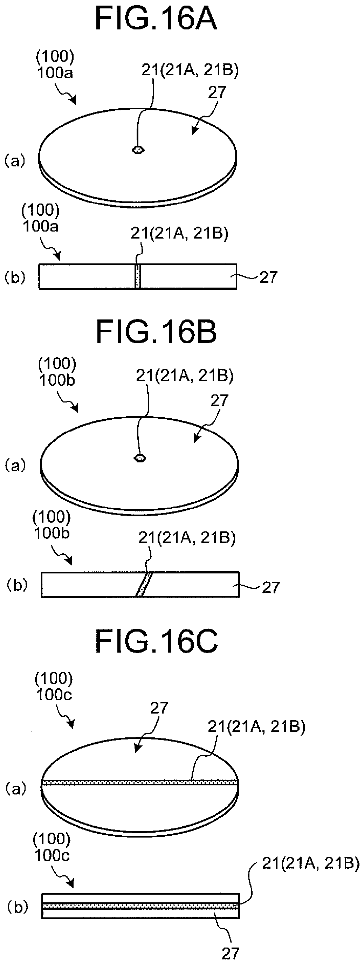

FIG. 14 and FIG. 15 are schematics illustrating a direction to slice the group 13 nitride crystal 19. FIG. 16A to FIG. 16C are schematics of an example of a group 13 nitride crystal substrate 100 (100a to 100c) obtained after the slicing.

By slicing the group 13 nitride crystal 19 in a direction perpendicular to the c-axis of the seed crystal (the first area 21) as indicated by a dashed-dotted line P1 in FIG. 14, for example, the group 13 nitride crystal substrate 100a illustrated in FIG. 16A is obtained. Alternatively, by slicing the group 13 nitride crystal 19 in a direction oblique to the c-axis of the seed crystal 21 as indicated by a dashed-dotted line P2 in FIG. 14, the group 13 nitride crystal substrate 100b illustrated in FIG. 16B may be obtained. Still alternatively, by slicing the group 13 nitride crystal 19 in a direction parallel to the c-axis of the seed crystal 21 as indicated by a dashed-dotted line P3 in FIG. 14, the group 13 nitride crystal substrate 100c illustrated in FIG. 16C may be obtained.

After the slicing described above, various types of processing such as forming and surface treatment may be performed.

In the manufacturing method according to the present embodiment, the group 13 nitride crystal substrate 100 is cut out from the group 13 nitride crystal 19 elongated in the c-axis direction as described above. Therefore, it is possible to make the substrate principal surface large both in the case of cutting out the c-plane and a plane other than the c-plane. In other words, according to the present embodiment, it is possible to manufacture the large-area crystal substrate 100 having the principal surface formed of an arbitrary crystal plane, such as the c-plane, the m-plane, the a-plane, the {10-11} plane, a {20-21} plane, and a {11-22} plane. Therefore, it is possible to manufacture the group 13 nitride crystal substrate 100 in practical size that is applicable to various types of semiconductor devices.

In the manufacturing method according to the present embodiment, because the crystal substrate 100 whose principal surface is formed of the c-plane has a BPD extending in a plurality of directions different from one another, distortion and warpage are suppressed. Therefore, the crystal substrate 100 is more suitably used as a seed crystal substrate for various types of semiconductor devices.

In the manufacturing method according to the present embodiment, the group 13 nitride crystal substrate 100 is manufactured by slicing a group 13 nitride bulk crystal (the group 13 nitride crystal 19). Unlike the conventional technology, there is no process for separating a thick-film crystal grown on a dissimilar substrate that is significantly different in the coefficient of thermal expansion and in the lattice constant from the substrate. As a result, a crack is less likely to occur on the group 13 nitride crystal substrate 100 in the manufacturing method according to the present embodiment. Therefore, it is possible to manufacture the group 13 nitride crystal substrate 100 of higher quality than that of the conventional technology.

### [5] Preferable shape of the group 13 nitride crystal (bulk crystal)

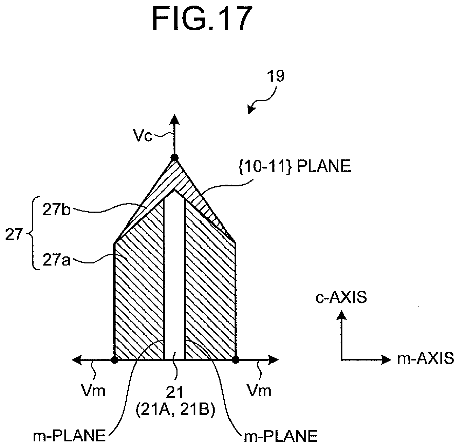

A preferable shape of the group 13 nitride crystal 19 will now be described. FIG. 17 to FIG. 19 are schematics for explaining a process in which the second area 27 is grown from the seed crystal of the first area 21A (including the third area 29a and the fourth area 29b), the first area 21B, or the first area 21. In the description below, the crystal growth method is not particularly restricted. FIG. 17 to FIG. 19 illustrate a section on a plane parallel to the c-axis and the a-axis of the group 13 nitride crystal 19.

As illustrated in FIG. 17, the group 13 nitride crystal 19 includes an area 27a and an area 27b. The area 27a is grown mainly in the m-axis direction (that is, a direction in which the c-plane section of the hexagon becomes larger) from the m-plane serving as the outer circumferential surface of the seed crystal of the first area 21, the first area 21A, or the first area 21B. The area 27b is grown mainly from the {10-11} plane of the seed crystal or the {10-11} plane on the upper surface of the area 27a.

In the area 27b, the rate of formation of the {10-11} plane may be limited. As a result, the group 13 nitride crystal 19 (second area 27) grown around the upper portion of the seed crystal is likely to have a hexagonal pyramid shape.

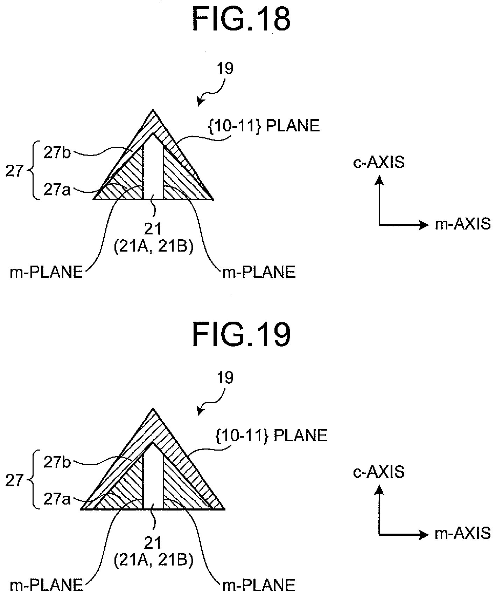

FIG. 18 is a schematic illustrating a state of crystal growth in the case where a length L of the seed crystal in the c-axis direction is short. If the length L of the seed crystal is not sufficiently long, the ratio of the hexagonal pyramid portion to the hexagonal columnar portion is made large. As a result, the volume ratio of the area 27b formed in a <10-11> direction to the area 27a formed in the m-axis direction is made larger. Thus, the group 13 nitride crystal 19 is likely to have the shape illustrated in FIG. 19. In this case, all the c-plane sections include the area 27b.

FIG. 19 is a schematic illustrating a state in which the crystal growth of the group 13 nitride crystal (second area 27) in FIG. 18 is further promoted. As illustrated in FIG. 19, if the outer circumference of the seed crystal is surrounded by the area 27b, no outer circumferential surface composed of the m-plane is formed even if further crystal growth is performed. As a result, it is frequently observed that the group 13 nitride crystal (second area 27) grows while the {10-11} plane is being kept as the outer circumferential surface.

The area 27a is an area that starts to grow from the outer circumferential surface of the m-plane of the seed crystal. As described above, the group 13 nitride crystal (area 27a) grown mainly from the m-plane of the seed crystal has a relatively small number of threading dislocations extending in the c-axis direction. Therefore, in manufacturing of the group 13 nitride crystal substrate having the principal surface formed of the c-plane, it is preferable that the group 13 nitride crystal substrate include the area 27a as much as possible.

### [6] Preferable size of the seed crystal

A preferable shape of the seed crystal used for growing the group 13 nitride crystal 19 in the preferable shape described above will now be explained. The seed crystal of the first area 21A has a hexagonal crystal structure, and the angle formed by the a+c axis (<11-23> direction) and the c-plane is 58.4 degrees, for example. Furthermore, if the ratio L/d of the length L of the seed crystal of the first area 21A in the c-axis direction to a crystal diameter d on the c-plane section is 0.813, for example, the seed crystal has a hexagonal pyramid shape.

As described above, to obtain the group 13 nitride crystal 19 of high quality, it is preferable that the group 13 nitride crystal (second area 27) grow mainly from the outer circumferential surface of the m-plane of the seed crystal. Thus, the seed crystal preferably includes the m-plane as the outer circumferential surface thereof.

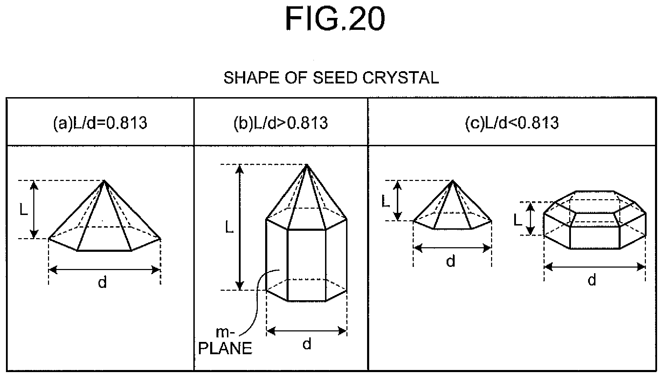

FIG. 20 is a schematic illustrating the relationship between the shape of the seed crystal of the first area 21A and L/d. As illustrated in FIG. 20, if (a) L/d = 0.813 is satisfied, the seed crystal has a hexagonal pyramid shape. If (b) L/d > 0.813 is satisfied, the upper part has a hexagonal pyramid shape and the lower part has a hexagonal columnar shape, and the outer circumferential surface (side surface) of the seed crystal includes the m-plane. If (c) L/d < 0.813 is satisfied, the seed crystal has a hexagonal pyramid shape not including the m-plane or a shape in which a part including the apex of the hexagonal pyramid portion is not included, the c-plane is formed on the upper surface of the crystal, and the height of the hexagonal columnar portion including the m-plane is short.

Therefore, the ratio L/d of the length L in the c-axis direction to the crystal diameter d on the c-plane is preferably larger than 0.813 in the seed crystal.

The size of the group 13 nitride crystal substrate 100 is desired to be half an inch (12.7 mm) or 2 inches (5.08 cm) for practical use. Thus, an explanation will be made of the size of the seed crystal required for making the maximum diameter of the group 13 nitride crystal substrate 100 having the principal surface formed of the c-plane equal to or larger than half an inch (12.7 mm) or equal to or larger than 2 inches.

In the description below, an estimation will be made of the case where the thickness of the group 13 nitride crystal substrate 100 is 1 mm as an example of the minimum thickness required to be a practical substrate. However, the required minimum thickness is not limited thereto and is arbitrarily estimated.

To cause the diameter of the group 13 nitride crystal substrate 100 to be 12.7 mm, that is, to cause a diameter d of the group 13 nitride crystal substrate 100 to be 12.7 mm, the second area 27 needs to grow by at least equal to or more than 6.35 mm in the radial direction (m-axis direction) assuming that the crystal diameter of the seed crystal is 0.

An assumption is made that a crystal growth velocity Vm in the m-axis direction is twice as fast as a crystal growth velocity Vc in the c-axis direction, for example. In this case, the group 13 nitride crystal grows by approximately 3.2 mm in the c-axis direction while growing by 6.35 mm in the m-axis direction. Because L/d > 0.813 is satisfied as described above, the length L in the c-axis direction (the height of the hexagonal pyramid portion) needs to be 11.9 mm to cause the crystal diameter d (the diameter of the bottom surface of the hexagonal pyramid portion) to be 12.7 mm. Therefore, it is estimated that the length of the seed crystal 30 needs to be 11.9 - 3.2 = 8.7 mm. In other words, the minimum length of the seed crystal required to obtain the group 13 nitride crystal in a hexagonal pyramid shape is 8.7 mm. Furthermore, an area in a hexagonal columnar shape is required to be formed under the hexagonal pyramid. Assuming that the thickness of the group 13 nitride crystal substrate 100 needs to be equal to or larger than 1 mm, it is estimated that the length L of the seed crystal 30 in the c-axis direction needs to be 9.7 mm.

As described above, the length L of the seed crystal (seed crystal of the first area 21, the first area 21A, or the first area 21B) in the c-axis direction is preferably equal to or larger than 9.7 mm.

Preferably, the ratio L/d of the length L in the c-axis direction to the crystal diameter d on the c-plane is larger than 0.813, and the length L in the c-axis direction is equal to or larger than 9.7 mm. The ratio L/d is more preferably larger than 7 and still more preferably larger than 20.

As described above, according to the preferred embodiment, it is possible to manufacture the group 13 nitride crystal substrate 100 having a diameter on the c-plane of half an inch. Furthermore, because the group 13 nitride crystal 19 grown from the m-plane of the seed crystal is of high quality as described above, it is possible to manufacture the group 13 nitride crystal substrate 100 that is large in size and excellent in quality.

To obtain the group 13 nitride crystal substrate 100 having a diameter of 2 inches (5.08 cm), it is estimated that the length L of the seed crystal in the c-axis direction needs to be equal to or larger than 37.4 mm.

Therefore, the length L of the seed crystal in the c-axis direction is preferably equal to or larger than 37.4 mm. Thus, it is possible to manufacture the group 13 nitride crystal substrate 100 having a diameter of the c-plane of equal to or larger than 2 inches. Furthermore, because the group 13 nitride crystal 19 grown from the m-plane of the seed crystal is of high quality as described above, it is possible to manufacture the group 13 nitride crystal substrate 100 with a large diameter and of high quality.

### Examples

While examples will be described below to explain the present invention in greater detail, the examples are not intended to limit the present invention. Reference numerals correspond to those in the configurations of the crystal producing apparatuses 1 and 2 described with reference to FIG. 11 and FIG. 12.

### Production of seed crystal

A seed crystal used for production of a group 13 nitride crystal was produced by the following production method.

### Production example 1 of the seed crystal

The seed crystal of the first area 21A was produced using the crystal producing apparatus 1 illustrated in FIG. 11.

Gallium with a nominal purity of 99.99999% and sodium with a nominal purity of 99.95% were input in a molar ratio of 0.25:0.75 to the reaction container 12 with an inside diameter of 92 mm made of a BN sintered compact.

The reaction container 12 was placed in the pressure-resistant container 11 under a high-purity Ar gas atmosphere in a glove box. Subsequently, the valve 31 was closed to isolate the inside of the reaction container 12 from an external atmosphere, and the pressure-resistant container 11 was sealed up in a manner filled with the Ar gas.

Subsequently, the pressure-resistant container 11 was taken out of the glove box and incorporated into the crystal producing apparatus 1. In other words, the pressure-resistant container 11 was placed at a predetermined position with respect to the heater 13 and connected to the gas supply pipe 14 for a N₂ gas and an Ar gas at the portion of the valve 31.

After the Ar gas was purged from the inner container 11, the N₂ gas was injected from the N₂ supply pipe 17. The pressure of the N₂ gas was controlled by the pressure control device 16, and the valve 15 was opened. Thus, the pressure of N₂ in the inner container 11 was set to 3.2 MPa. Subsequently, the valve 15 was closed, and the value of the pressure control device 16 was set to 8 MPa. The heater 13 was then turned ON to heat the reaction container 12 to the crystal growth temperature. In Production example 1, the crystal growth temperature was set to 870 degrees C.

The gallium and the sodium in the reaction container 12 are melted at the crystal growth temperature to form the mixed melt 24. The temperature of the mixed melt 24 is equal to the temperature of the reaction container 12. Furthermore, if the reaction container 12 is heated to this temperature, a gas in the inner container 11 is heated to cause the total pressure to be 8 MPa in the crystal producing apparatus 1 in Production example 1.

Subsequently, the valve 15 was opened to cause the pressure of the N₂ gas to be 8 MPa, thereby achieving the pressure equilibrium between the inside of the inner container 11 and the inside of the N₂ supply pipe 17.

After the reaction container 12 was held in this state for 500 hours to perform crystal growth of GaN, the heater 13 was controlled to cool the inner container 11 to room temperature (approximately 20 degrees C). After the pressure of the gas in the inner container 11 was reduced, the inner container 11 was opened. As a result, it was found that a large number of GaN crystals were grown in the reaction container 12. The seed crystal 30, which is the GaN crystal thus grown, was colorless and transparent. The crystal diameter d of the seed crystal 30 was approximately 100 to 1500 µm, the length L thereof was approximately 10 to 40 mm, and the ratio L/d of the length L to the crystal diameter d was approximately 20 to 300. The seed crystal 30, which is the GaN crystal thus grown, was grown nearly parallel to the c-axis, and the m-plane was formed on the side surface thereof.

### Production example 2 of the seed crystal

Crystal growth was performed in the same manner as in Production example 1 of the seed crystal except for the following conditions: alumina was used as the material of the reaction container 12; a plate made of a BN sintered compact fitting into the bottom surface of the reaction container 12 was placed; the partial pressure of N₂ in the pressure-resistant container 11 at a crystal growth temperature of 870 degrees C was maintained at 6 MPa (the partial pressure of N₂ in the pressure-resistant container 11 at room temperature is 2.8 MPa); and crystal growth time was set to 300 hours.

As a result, similarly to Production example 1 of the seed crystal, it was found that a large number of colorless and transparent seed crystals 30, which are grown GaN crystals, were grown. The crystal diameter d of the seed crystal 30 was approximately 100 to 500 µm, the length L thereof was approximately 10 to 15 mm, and the ratio L/d of the length L to the crystal diameter d was approximately 30 to 500.

### Production example 3 of the seed crystal

Crystal growth was performed in the same manner as in Production example 1 of the seed crystal except that the crystal growth temperature was set to 860 degrees C and the pressure of N₂ was set to 5 MPa. As a result, a GaN microcrystal having a size of approximately several hundred micrometers was obtained. However, no GaN single crystal having a length of equal to or larger than 3 mm was obtained.

Various types of measurement were performed on each seed crystal 30 produced in Production example 1 of the seed crystal and Production example 2 of the seed crystal. The measurement results are as follows.

### Measurement results of photoluminescence (PL)

Photoluminescence (PL) of the seed crystal produced in Production example 1 of the seed crystal and PL of the seed crystal produced in Production example 2 of the seed crystal were measured at room temperature (25 degrees C). The PL was measured using LabRAM HR-80 manufactured by HORIBA, Ltd. A helium-cadmium (He-Cd) laser at a wavelength of 325 nm was used as an excitation light source. The PL was measured in the third area 29a serving as the inner side area of the seed crystal 30 and the fourth area 29b serving as the outer side area of the seed crystal 30.

FIG. 10 illustrates an example of measurement results of an emission spectrum of the PL in the third area 29a and the fourth area 29b. The abscissa axis represents wavelengths (nm) and the ordinate axis represents emission intensity.

As indicated by a solid line in FIG. 10, broad emission (the second peak) from 500 nm to 800 nm having a peak at around 600 nm was detected in the third area 29a in Production example 1 of the seed crystal and Production example 2 of the seed crystal. However, only extremely low emission intensity was detected in light emission (the first peak) in the vicinity of the band-edge of GaN (364 nm).

By contrast, as indicated by a dotted line in FIG. 10, high peak intensity was detected in light emission (the first peak) in the vicinity of the band-edge of GaN (364 nm) in the fourth area 29b in Production example 1 of the seed crystal and Production example 2 of the seed crystal. However, only extremely low emission intensity was detected in broad emission (the second peak) from 500 nm to 800 nm.

As described above, in terms of the seed crystal 30 produced in Production example 1 of the seed crystal and Production example 2 of the seed crystal, it was found that the peak intensity of the first peak was lower than the peak intensity of the second peak in the third area 29a on the inner side of the seed crystal 30. Furthermore, it was found that the peak intensity of the first peak was higher than the peak intensity of the second peak in the fourth area 29b on the outer side of the seed crystal 30.

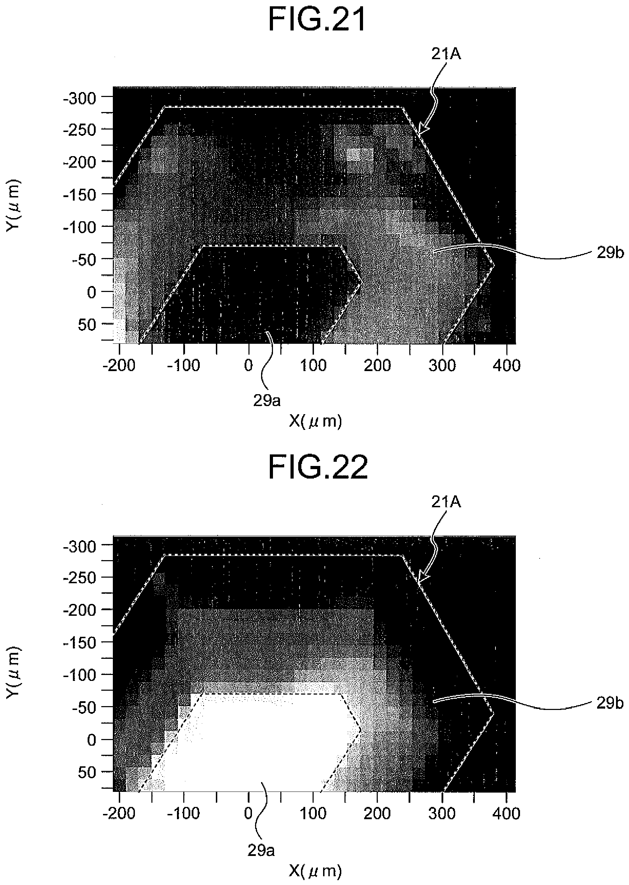

An explanation will be made of emission intensity distribution of the PL measured for the seed crystal 30 produced in Production example 1 of the seed crystal and Production example 2 of the seed crystal with reference to FIG. 21 and FIG. 22. FIG. 21 and FIG. 22 are views of examples of PL results measured on the c-plane section of the seed crystal 30 produced in Production example 1 of the seed crystal and Production example 2 of the seed crystal and illustrate spectral intensity at different wavelength bands at the same measurement point on the c-plane section.

FIG. 21 is a view of a mapping image of spectral intensity of the PL from 360 nm to 370 nm. A deeper color indicates higher spectral intensity in a range of 360 nm to 370 nm.

FIG. 22 is a view of a mapping image of spectral intensity of the PL from 500 nm to 800 nm. A deeper color indicates higher spectral intensity in a range of 500 nm to 800 nm.

Therefore, according to the mapping results in FIG. 21 and FIG. 22, it was found that the third area 29a was located on the inner side of the seed crystal 30 produced in Production example 1 of the seed crystal and Production example 2 of the seed crystal and that the fourth area 29b was located on the outer side thereof.

As a result of PL measurement performed on the c-plane section of the seed crystal 30 produced in Production example 1 of the seed crystal and Production example 2 of the seed crystal, it was found that the fourth area 29b covered the entire outer circumference of the third area 29a in some seed crystals 30. Furthermore, it was found that the fourth area 29b covered a part of the outer circumference of the third area 29a in the other seed crystals 30. Thus, it was found that the fourth area 29b covered at least a part of the outer circumference of the third area 29a on the c-plane section of the seed crystal 30 produced in Production example 1 of the seed crystal and Production example 2 of the seed crystal.

### Measurement of boron concentration

The boron concentration in the seed crystal 30 produced in Production example 1 of the seed crystal and Production example 2 of the seed crystal was measured using a secondary ion mass spectrometer (SIMS). IMS 7f (a model designation) manufactured by CAMECA was used as the SIMS. A Cs⁺ ion was used as a primary ion beam. In the present measurement, the boron concentration was measured at a plurality of points in the inner side area (that is, the third area 29a) and the outer side area (that is, the fourth area 29b) on the c-plane section of the seed crystal 30.

While there was a little fluctuation in the measurement results depending on the positions, the boron concentration of the third area 29a was approximately 5 × 10¹⁸ cm⁻³ to 3 × 10¹⁹ cm⁻³, and the boron concentration of the fourth area 29b was approximately 1 × 10¹⁶ cm⁻³ to 8 × 10¹⁷ cm⁻³.

Thus, it was found that the boron concentration of the fourth area 29b on the outer side on the c-plane section was lower than the boron concentration of the third area 29a on the inner side in the seed crystal 30 produced in Production example 1 of the seed crystal and Production example 2 of the seed crystal.

By the crystal production method described above, the group 13 nitride crystal 19 was produced using the seed crystal 30 produced in Production example 1 of the seed crystal and Production example 2 of the seed crystal.

### Example A1

In Example A1, the second area 27 was grown from the seed crystal 30 to produce the group 13 nitride crystal 19 by the crystal producing apparatus 2 illustrated in FIG. 12.

The seed crystal 30 produced in Production example 1 of the seed crystal was used as the seed crystal 30. The seed crystal 30 had a width of 1 mm and a length of approximately 40 mm. In the seed crystal 30 used in Example A1, the fourth area 29b covered the entire outer circumference of the third area 29a on at least a part of the c-plane sections. Furthermore, it was found that a thickness t (thickness in the m-axis direction) of the fourth area 29b was at least equal to or larger than 10 µm on the c-plane section of the seed crystal 30.

The inner container 51 was detached from the crystal producing apparatus 2 at the portion of the valve 61 and put into a glove box under an Ar atmosphere. Subsequently, the seed crystal 30 was placed in the reaction container 52 made of alumina and having an inside diameter of 140 mm and a depth of 100 mm. The seed crystal 30 was held in a manner inserted into a hole with a depth of 4 mm bored on the bottom of the reaction container 52.

Subsequently, sodium (Na) was heated into a liquid and input to the reaction container 52. After the sodium solidified, gallium was input. In Example A1, the molar ratio of the gallium to the sodium was set to 0.25:0.75.

Subsequently, the reaction container 52 was placed in the inner container 51 under a high-purify Ar gas atmosphere in the glove box. The valve 61 was then closed to seal up the inner container 51 filled with the Ar gas, and the inside of the reaction container 52 was isolated from an external atmosphere. Subsequently, the inner container 51 was taken out of the glove box and incorporated into the crystal producing apparatus 2. In other words, the inner container 51 was placed at a predetermined position with respect to the heater 53 and connected to the gas supply pipe 54 at the portion of the valve 61.

After the Ar gas was purged from the inner container 51, the N₂ gas was injected from the N₂ supply pipe 57. The pressure of the N₂ gas was controlled by the pressure control device 56, and the valve 55 was opened. Thus, the total pressure in the inner container 51 was caused to be 1.2 MPa. Subsequently, the valve 55 was closed, and the value of the pressure control device 56 was set to 3.2 MPa.

The heater 53 was then turned ON to heat the reaction container 52 to the crystal growth temperature. The crystal growth temperature was set to 870 degrees C. Subsequently, in the same manner as in the production in Production Example A1 of the seed crystal, the valve 55 was opened to cause the pressure of the N₂ gas to be 3.2 MPa. The reaction container 52 was held in this state for 1300 hours to grow a GaN crystal.

As a result, crystal growth was performed from the seed crystal 30, and the crystal diameter was increased in a direction perpendicular to the c-axis, whereby the group 13 nitride crystal 19 (single crystal) having a larger crystal diameter was grown in the reaction container 52. The group 13 nitride crystal 19 obtained by the crystal growth was roughly colorless and transparent. The crystal diameter d was 51 mm, and the length L in the c-axis direction was approximately 54 mm including the portion of the seed crystal 30 inserted into the reaction container 52. In the group 13 nitride crystal 19, the upper part had a hexagonal pyramid shape and the lower part had a hexagonal columnar shape.

### Example A2

In Example A2, crystal growth of the seed crystal 30 was performed to produce the group 13 nitride crystal 19 by the crystal producing apparatus 2 illustrated in FIG. 12 under the same conditions as those in Example A1 except that the seed crystal 30 produced in Production example 2 of the seed crystal was used as the seed crystal.

The group 13 nitride crystal 19 obtained in Example A2 had a hexagonal pyramid shape.

### Comparative example A1

In Comparative example A1, a crystal having a defect extending in a different direction because of difference in the growth direction from Example A1 was produced. In Comparative example A1, crystal growth was performed such that the crystal was grown in the c-axis direction using the group 13 nitride crystal substrate having the principal surface formed of the c-plane and produced in Example B1 as the seed crystal. The c-plane diameter of the seed crystal was 50.8 mm, and the thickness of the substrate was 400 µm.

The inner container 51 was detached from the crystal producing apparatus 2 at the portion of the valve 61 and put into a glove box under an Ar atmosphere. Subsequently, the group 13 nitride crystal substrate 100 was placed in the reaction container 52 made of alumina and having an inside diameter of 140 mm and a depth of 100 mm. Subsequently, sodium (Na) was heated into a liquid and input to the reaction container 52. After the sodium solidified, gallium was input. In Comparative example A1, the molar ratio of the gallium to the sodium was set to 0.25:0.75.

Subsequently, the reaction container 52 was placed in the inner container 51 under a high-purify Ar gas atmosphere in the glove box. The valve 61 was then closed to seal up the inner container 51 filled with the Ar gas, and the inside of the reaction container 52 was isolated from the external atmosphere. Subsequently, the inner container 51 was taken out of the glove box and incorporated into the crystal producing apparatus 2. In other words, the inner container 51 was placed at a predetermined position with respect to the heater 53 and connected to the gas supply pipe 54 at the portion of the valve 61. After the Ar gas was purged from the inner container 51, the N₂ gas was injected from the N₂ supply pipe 57. The pressure of the N₂ gas was controlled by the pressure control device 56, and the valve 55 was opened. Thus, the total pressure in the inner container 51 was caused to be 1.0 MPa. Subsequently, the valve 55 was closed, and the value of the pressure control device 56 was set to 3 MPa.

The heater 53 was then turned ON to heat the reaction container 52 to the crystal growth temperature. The crystal growth temperature was set to 870 degrees C. Subsequently, in the same manner as the operation in Example 1, the valve 55 was opened to cause the pressure of the N₂ gas to be 2.5 MPa. The reaction container 52 was held in this state for 700 hours to grow a GaN crystal (the second area 27).

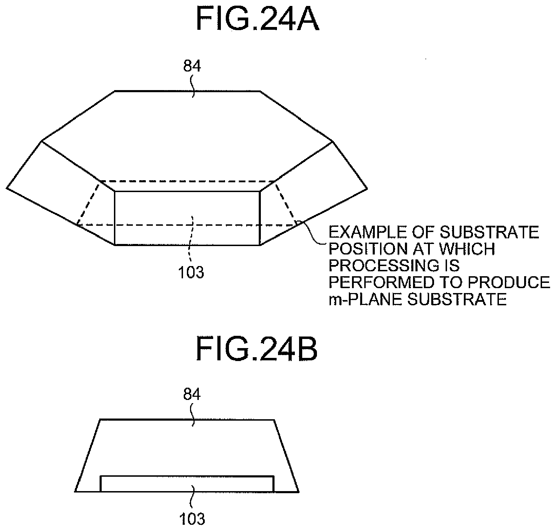

As a result, the thickness of the crystal substrate was increased in the c-axis direction, and a GaN crystal (single crystal) was grown in the reaction container 52. A GaN crystal 84 thus grown was roughly colorless and transparent, and the length L in the c-axis direction was approximately 8 mm (refer to FIG. 24A).

Subsequently, a group 13 nitride crystal substrate was manufactured using the group 13 nitride crystal produced in Example A1 and Comparative example A1.

### Example B1

The group 13 nitride crystal produced in Example A1 was subjected to external shape grinding and was sliced parallel to the c-plane. Subsequently, by polishing the surface and performing surface treatment thereon, a group 13 nitride crystal substrate having the principal surface formed of the c-plane with an external shape (φ) of 2 inches and a thickness of 400 µm and including a first area and a second area was manufactured.

### Example B2

The group 13 nitride crystal produced in Example A2 was subjected to external shape grinding and was sliced parallel to the c-plane. Subsequently, by polishing the surface and performing surface treatment thereon, a group 13 nitride crystal substrate having the principal surface formed of the c-plane and including a first area and a second area was manufactured.

### Example B3

The group 13 nitride crystal produced in Example A1 was subjected to external shape grinding and was sliced parallel to the m-plane. Subsequently, by polishing the surface and performing surface treatment thereon, a group 13 nitride crystal substrate 101 having the principal surface formed of the m-plane with a height of 40 mm, a width of 25 mm, and a thickness of 400 µm and a group 13 nitride crystal substrate 102 having the principal surface formed of the m-plane with a height of 40 mm, a width of 40 mm, and a thickness of 400 µm were manufactured (refer to FIG. 4 and FIG. 5). The crystal substrate 102 includes the seed crystal.

### Comparative example B1

A c-plane substrate was manufactured under the same conditions as those in Example B1 except that the group 13 nitride crystal produced in Comparative Example A1 was used instead of the group 13 nitride crystal produced in Example A1. FIG. 24B is a schematic of an m-plane section of the GaN crystal 84 produced in Comparative example A1. The c-plane substrate did not include a portion of a GaN substrate 103 serving as the seed crystal and was manufactured from the portion of the GaN crystal 84 grown from the seed crystal substrate in the c-axis direction.

### Comparative example B2

An m-plane substrate (refer to FIG. 24B) with a height of 7 mm, a width of 15 mm, and a thickness of 400 µm was manufactured by processing an m-plane substrate under the same conditions as those in Example B3 except that the group 13 nitride crystal produced in Comparative Example A1 was used instead of the group 13 nitride crystal produced in Example A1.

### Evaluation

### Evaluation of dislocation density

Evaluation was made on the dislocation direction, the dislocation density, the grain boundary, and the grain boundary density of each c-plane of the group 13 nitride crystal substrate serving as a c-plane substrate manufactured in Example B1, Example B2, and Comparative example B1.

Specifically, each c-plane surface of the group 13 nitride crystal substrate serving as a c-plane substrate manufactured in Example B1, Example B2, and Comparative example B1 was observed by CL. MERLIN manufactured by Carl Zeiss was used as a CL device, and the observation was made at an accelerating voltage of 5.0 kV, a probe current of 4.8 nA, and room temperature.

The threading dislocation density threading through the c-plane of the group 13 nitride crystal substrate manufactured in Example B2 was equal to or lower than 10² cm⁻². This value was derived by counting spots found as dark spots by CL on the c-plane. In the CL observation of the c-plane of the group 13 nitride crystal substrate, if a dislocation extending in a direction not parallel to the c-axis and the c-plane, such as the <11-23> direction, is present on the c-plane surface, the dislocation is found as a short dark line, for example. On the c-plane of the group 13 nitride crystal substrate manufactured in Example B2, however, no short dark line was found. Therefore, it was found that there were few dislocations not parallel to the c-axis and the c-plane in the group 13 GaN crystal according to the present embodiment.

In the same manner as in Example B1 and Example B2, the threading dislocation density in a direction threading through the c-plane was measured for the group 13 nitride crystal substrate manufactured in Comparative example B1 and having the principal surface formed of the c-plane. As a result, a threading dislocation density of approximately from 10⁴ cm⁻² to 10⁵ cm⁻² was found. Furthermore, the group 13 nitride crystal substrate manufactured in Comparative example B1 had an area in which dislocations were concentrated, and a grain boundary was found to be present based on contrast in the CL observation image. The grain boundary density of Comparative example B1 was 10 to 100 cm⁻².

### Crystallinity evaluation 1

The crystallinity was evaluated for each c-plane of the group 13 nitride crystal substrate serving as a c-plane substrate and manufactured in Example B1 and Example B2.

Specifically, the crystallinity of each c-plane of the group 13 nitride crystal substrate serving as a c-plane substrate and manufactured in Example B1 and Example B2 was evaluated by a half width of a rocking curve in X-ray diffraction (XRD) measurement. X' Pro MRD manufactured by PANalytical was used for the XRD measurement. As a result, it was found that the half width of the rocking curve of the c-plane substrate surface was high quality of 25 to 50 arcsec.

Thus, no grain boundary was present in the second area on the c-plane of the group 13 nitride crystal produced in Example A1 and Example A2, and a grain boundary was present only in the interface between the first area serving as a seed crystal and the second area grown from the seed crystal. The grain boundary density was derived for the entire area on the c-plane, that is, the entire area of the first area serving as the seed crystal and the second area grown from the seed crystal. As a result, the number of grain boundaries per 1 cm² was 1.

Thus, it was found that the dislocation density of the BPD on the c-plane of the group 13 nitride crystal produced in Example A1 and Example A2 was higher than the grain boundary density on the c-plane. Furthermore, it was found that the number of grain boundaries on the c-plane of the group 13 nitride crystal produced in Example A1 and Example A2 per 1 cm² was equal to or less than 1.

To obtain the group 13 nitride crystal substrate including no grain boundary, the group 13 nitride crystal substrate may be cut out from the group 13 nitride crystal produced in Example A1 and Example A2 such that the group 13 nitride crystal substrate includes not the first area serving as the seed crystal but the second area grown from the seed crystal alone.

In the same manner as described above, the crystallinity of the group 13 nitride crystal substrate manufactured in Comparative example B1 and having the principal surface formed of the c-plane was evaluated by a half width of a rocking curve in XRD measurement. As a result, it was found that the half width of the rocking curve of the c-plane substrate surface was 100 to 200 arcsec and that the group 13 nitride crystal substrate manufactured in Comparative example B1 was of lower quality than the substrates manufactured in Example B1 and Example B2.

### Crystallinity evaluation 2

The crystallinity was evaluated for the group 13 nitride crystal substrate 101 and the group 13 nitride crystal substrate 102 serving as m-plane substrates and manufactured in Example B3.

The dislocation density was measured for the m-plane surface serving as the principal surface of the group 13 nitride crystal substrate 101 by using CL. As a result, dislocations were mainly found as short dark lines, and the density of a dislocation threading through the m-plane surface was approximately from 10⁴ cm⁻² to 10⁶ cm⁻². The group 13 nitride crystal substrate 101 had an area in which dislocations were concentrated, and a grain boundary was found to be present based on contrast in the CL observation image. The grain boundary density was 10 to 100 cm⁻².

The m-plane surface serving as the principal surface of the crystal substrate 102 was observed by CL. As a result, a number of dislocations were found as dark lines extending in directions parallel to the c-plane. Furthermore, there was an area in which dislocations extending in directions parallel to the c-plane were concentrated in a stacked manner, and a grain boundary was found to be present in a direction parallel to the c-plane.

There was an area in which dislocations were concentrated around the interface between the area of the seed crystal and the area grown from the seed crystal. In the area around the interface in which dislocations were concentrated, a dislocation extending in a direction not parallel to the c-plane, such as the <11-23> direction, was present.

Furthermore, a plurality of dislocations extending in directions outward from the seed crystal were found.

Thus, it was found that BPDs of the group 13 nitride crystal produced in Example A2, which is a base of the group 13 nitride crystal substrate manufactured in Example B3, included dislocations extending in directions from the first area serving as the seed crystal to the second area grown from the seed crystal.

In the same manner as described above, the dislocation density of the BPD and the BPD were measured for the group 13 nitride crystal substrate manufactured in Example B1 and Example B2. As a result, it was found that the dislocation density of the BPD was higher than the dislocation density of the threading dislocation extending in a direction threading though the c-plane.

Thus, it was found that the dislocation density of the BPD in the group 13 nitride crystal produced in Example A1 and Example A2 was higher than the dislocation density of the threading dislocation extending in a direction threading though the c-plane.

If the BPD is present in a plurality of directions, the group 13 nitride crystal substrate can be of high quality with a little distortion and warpage. Therefore, even if the group 13 nitride crystal substrate was cut out from the group 13 nitride crystal produced in Example A1 and Example A2 such that the group 13 nitride crystal substrate includes the first area serving as the seed crystal, the group 13 nitride crystal substrate can be of high quality with a little distortion and warpage compared with the conventional group 13 nitride substrate.

From the evaluation results described above, it was found that the dislocation density of the BPD was higher than the grain boundary density on the c-plane in the group 13 nitride crystal produced in Example A1 and Example A2.

Furthermore, it was found that a crystal substrate having lower dislocation density and a smaller grain boundary can be manufactured by processing the crystal so as to have the principal surface formed of the c-plane.

In the same manner as described above, the BPD dislocation density was measured for the group 13 nitride crystal substrate manufactured in Comparative example B2 and having the principal surface formed of the m-plane. As a result, dislocations were found mainly as short dark lines, but the density of the dislocation threading through the m-plane surface was equal to or lower than 10² cm².

Thus, it was found that the group 13 nitride crystal produced in Comparative example A1 did not satisfy the relationship between the threading dislocation and the basal plane dislocation in the group 13 nitride crystal produced in Example A1 and Example A2.

### PL evaluation

PL was measured at room temperature for the c-plane section of the group 13 nitride crystal substrate manufactured in Example B1. A He-Cd laser at a wavelength of 325 nm was used as an excitation light source.

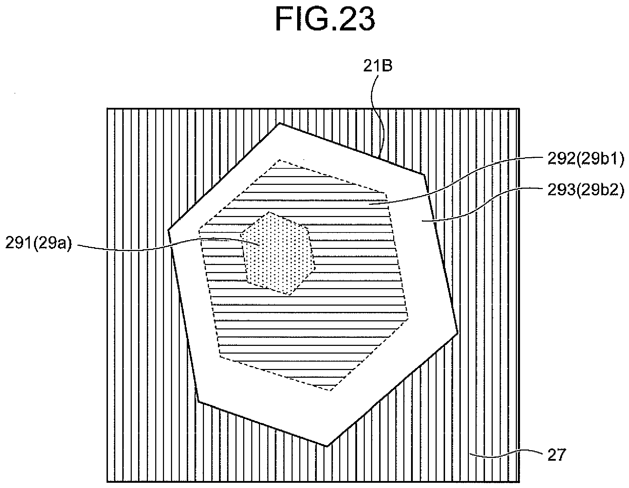

FIG. 23 is a view schematically illustrating emission distribution of PL in the group 13 nitride crystal substrate manufactured in Example B1. The area of the seed crystal (first area 21B) included areas 291 to 293 (the third area 29a and the fourth area 29b (the fourth area 29bl and the fourth area 29b2)) having different light emission properties, such as colors and intensity of the PL. It was assumed that the difference in the light emission properties, such as emission intensity and colors, among the areas was caused by difference in impurities contained in the areas and the amount of the impurities.

Because the area 291 is an area exhibiting intense red light emission and emits red light, it is found that light emission from 600 to 650 nm, which is light emission from other than the vicinity of the band edge of GaN, is intense in the area 291. In other words, the area 291 has the property of the third area 29a.

Because the area 292 is an area exhibiting intense blue light emission and emits light in a blue wavelength range, it is found that the light emission is from the band edge of GaN or the vicinity of the band edge. The area 293 is an area in which the emission intensity of blue light is lower than the emission intensity of blue light in the area 292. In the area 292 and the area 293, no orange or red light emission is found, and light emission from other than the vicinity of the band edge of GaN is not intense. In other words, the area 292 has the property of the fourth area 29b1, and the area 293 has the property of the fourth area 29b2. Furthermore, it was found that the thickness t (thickness in the m-axis direction) of the fourth area 29b was at least equal to or larger than 10 µm on the c-plane section of the seed crystal (first area 21B).

The GaN crystal in the second area 27 grown around the seed crystal 21B exhibited blue light emission.

As described above, from the results of the PL measurement, it was found that the c-plane of the crystal substrate 100 included the third area 29a and the fourth area 29b (the fourth area 29b1 and the fourth area 29b2). Furthermore, it was found that the third area 29a was covered by the fourth area 29b1 and that the fourth area 29b1 was covered by the fourth area 29b2.

According to the embodiments, it is possible to provide a group 13 nitride crystal and a group 13 nitride crystal substrate of high quality.

Although the invention has been described with respect to specific embodiments for a complete and clear disclosure, the present invention is defined by the appended claims.

## Claims

1. A group 13 nitride crystal (19) having a hexagonal crystal structure containing a nitrogen atom and at least Ga, the group 13 nitride crystal comprising:
a basal plane dislocation in a plurality of directions, wherein
dislocation density of the basal plane dislocation is higher than dislocation density of a threading dislocation of a c-plane;
a first area (21A, 21B) provided to an inner side of a section intersecting a c-axis, the first area serving as a seed crystal; and
a second area (27) provided to an outside of the first area on the section and grown from the first area, **characterised in that**
the first area has
a third area (29a) provided inside of the section and having a first peak including band-edge emission of GaN in an emission spectrum caused by electron beam excitation or ultraviolet light excitation and a second peak on the longer-wavelength side than the first peak, a peak intensity of the first peak being lower than a peak intensity of the second peak, and
a fourth area (29b) provided in a manner covering at least a part of the outer circumference of the third area and having a first peak including band-edge emission of GaN in an emission spectrum caused by electron beam excitation or ultraviolet light excitation and a second peak on the longer-wavelength side than the first peak, a peak intensity of the first peak being higher than a peak intensity of the second peak, the fourth area having a thickness of equal to or larger than 100nm,
wherein the boron concentration of the third area (29a) is higher than the boron concentration of the fourth area (29b).

2. The group 13 nitride crystal (19) according to claim 1, wherein the basal plane dislocation includes a dislocation extending in a direction from the first area to the second area.

3. The group 13 nitride crystal (19) according to claim 1 or 2, wherein the dislocation density of the basal plane dislocation is higher than grain boundary density on the c-plane.

4. The group 13 nitride crystal (19) according to any one of claims 1 to 3, wherein the grain boundary density of a section intersecting the c-plane is higher than the grain boundary density of the c-plane.

5. The group 13 nitride crystal (19) according to any one of claims 1 to 4, wherein the number of grain boundaries per 1 cm² on the c-plane is equal to or less than 1.

6. The group 13 nitride crystal (19) according to any one of claims 1 to 5, wherein the first peak is a peak of an emission spectrum appearing in a wavelength range of 364 nm in measurement at room temperature.

7. The group 13 nitride crystal (19) according to any one of claims 1 to 6, wherein the second peak falls within a wavelength range from 450nm to 650nm in measurement at room temperature.

8. The group 13 nitride crystal (19) according to claim 7, wherein the second peak falls within a wavelength range from 590nm to 650nm in measurement at room temperature.

9. A group 13 nitride crystal substrate (100) comprising the group 13 nitride crystal (19) according to any one of claims 1 to 8.

10. The group 13 nitride crystal (19) according to any one of claims 1 to 8, wherein the boron concentration of the third area (29a) is equal to or higher than 4x10¹⁸ atms/cm³, and the boron concentration of the fourth area (29b) is lower than 4x10¹⁸ atms/cm³.

11. The group 13 nitride crystal (19) according to claim 10, wherein the boron concentration of the third area (29a) is equal to or higher than 6x10¹⁸ atms/cm³, and the boron concentration of the fourth area (29b) is lower than 1x10¹⁸ atms/cm³.

## Patentansprüche

1. Gruppe-13-Nitridkristall (19) mit einer hexagonalen Kristallstruktur, die ein Stickstoffatom und mindestens Ga enthält, wobei der Gruppe-13-Nitridkristall Folgendes umfasst:
eine Versetzung der Basisfläche in eine Vielzahl von Richtungen, wobei
eine Versetzungsdichte der Versetzung der Basisfläche höher als eine Versetzungsdichte einer durchgehenden Versetzung einer c-Fläche ist;
einen ersten Bereich (21A, 21B), der einer Innenseite eines Abschnitts bereitgestellt ist, der eine c-Achse schneidet, wobei der erste Bereich als ein Impfkristall dient; und
einen zweiten Bereich (27), der einer Außenseite des ersten Bereichs an dem Abschnitt bereitgestellt ist und aus dem ersten Bereich gewachsen ist,
**dadurch gekennzeichnet, dass**
der erste Bereich Folgendes aufweist:
einen dritten Bereich (29a), der innerhalb des Abschnitts bereitgestellt ist und einen ersten Peak, der eine Bandkantenemission von GaN in einem Emissionsspektrum umfasst, das durch Elektronenstrahlanregung oder UV-Lichtanregung verursacht wird, und einen zweiten Peak auf der Seite längerer Wellenlänge als der erste Peak aufweist, wobei eine Peakintensität des ersten Peaks geringer als eine Peakintensität des zweiten Peaks ist, und
einen vierten Bereich (29b), der auf eine Weise bereitgestellt ist, dass er mindestens einen Teil des Außenumfangs des dritten Bereichs abdeckt und einen ersten Peak, der eine Bandkantenemission von GaN in einem Emissionsspektrum, das durch Elektronenstrahlanregung oder UV-Lichtanregung verursacht wird, und einen zweiten Peak auf der Seite längerer Wellenlänge als der erste Peak aufweist, wobei eine Peakintensität des ersten Peaks höher als eine Peakintensität des zweiten Peaks ist, wobei der vierte Bereich eine Stärke von gleich oder größer als 100 nm aufweist,
wobei die Borkonzentration des dritten Bereichs (29a) höher als die Borkonzentration des vierten Bereichs (29b) ist.

2. Gruppe-13-Nitridkristall (19) nach Anspruch 1, wobei die Versetzung der Basisfläche eine Versetzung umfasst, die sich in einer Richtung von dem ersten Bereich zu dem zweiten Bereich erstreckt.

3. Gruppe-13-Nitridkristall (19) nach Anspruch 1 oder 2, wobei die Versetzungsdichte der Versetzung der Basisfläche höher als eine Korngrenzendichte an der c-Fläche ist.

4. Gruppe-13-Nitridkristall (19) nach einem der Ansprüche 1 bis 3, wobei die Korngrenzendichte eines Abschnitts, der die c-Fläche schneidet, höher als die Korngrenzendichte der c-Fläche ist.

5. Gruppe-13-Nitridkristall (19) nach einem der Ansprüche 1 bis 4, wobei die Anzahl an Korngrenzen pro 1 cm² an der c-Fläche gleich oder weniger als 1 ist.

6. Gruppe-13-Nitridkristall (19) nach einem der Ansprüche 1 bis 5, wobei der erste Peak ein Peak eines Emissionsspektrums ist, der in einem Wellenlängenbereich von 364 nm bei der Messung bei Raumtemperatur erscheint.

7. Gruppe-13-Nitridkristall (19) nach einem der Ansprüche 1 bis 6, wobei der zweite Peak in einen Wellenlängenbereich von 450 nm bis 650 nm bei der Messung bei Raumtemperatur fällt.

8. Gruppe-13-Nitridkristall (19) nach Anspruch 7, wobei der zweite Peak in einen Wellenlängenbereich von 590 nm bis 650 nm bei der Messung bei Raumtemperatur fällt.

9. Gruppe-13-Nitridkristallsubstrat (100), umfassend den Gruppe-13-Nitridkristall (19) nach einem der Ansprüche 1 bis 8.

10. Gruppe-13-Nitridkristall (19) nach einem der Ansprüche 1 bis 8, wobei die Borkonzentration des dritten Bereichs (29a) gleich oder höher als 4x10¹⁸ Atome/cm³ ist und die Borkonzentration des vierten Bereichs (29b) geringer als 4x10¹⁸ Atome/cm³ ist.

11. Gruppe-13-Nitridkristall (19) nach Anspruch 10, wobei die Borkonzentration des dritten Bereichs (29a) gleich oder höher als 6x10¹⁸ Atome/cm³ ist und die Borkonzentration des vierten Bereichs (29b) geringer als 1x10¹⁸ Atome/cm³ ist.

## Revendications

1. Cristal de nitrure du groupe 13 (19) présentant une structure cristalline hexagonale contenant un atome d'azote et au moins Ga, le cristal de nitrure du groupe 13 comprenant :
une dislocation de plan de base dans une pluralité de directions,
une densité de dislocation de la dislocation de plan de base étant supérieure à une densité de dislocation d'une dislocation traversante d'un plan C ;
une première zone (21A, 21B) disposée sur un côté intérieur d'une section croisant un axe C, la première zone servant de germe cristallin ; et
une deuxième zone (27) disposée sur un côté extérieur de la première zone sur la section et cultivée à partir de la première zone,
**caractérisé en ce que** :
la première zone présente
une troisième zone (29a) disposée à l'intérieur de la section et présentant un premier pic comprenant une émission de bord de bande de GaN dans un spectre d'émission engendré par une excitation par faisceau d'électrons ou une excitation par lumière ultraviolette et un deuxième pic sur le côté de longueur d'onde plus longue que le premier pic, une intensité de pic du premier pic étant inférieure à une intensité de pic du deuxième pic, et
une quatrième zone (29a) disposée d'une manière à recouvrir au moins une partie de la circonférence externe de la troisième zone et présentant un premier pic comprenant une émission de bord de bande de GaN dans un spectre d'émission engendré par une excitation par faisceau d'électrons ou une excitation par lumière ultraviolette et un deuxième pic sur le côté de longueur d'onde plus longue que le premier pic, une intensité de pic du premier pic étant supérieure à une intensité de pic du deuxième pic, la quatrième zone présentant une épaisseur égale ou supérieure à 100 nm,
la concentration de bore de la troisième zone (29a) étant supérieure à la concentration de bore de la quatrième zone (29b).

2. Cristal de nitrure du groupe 13 (19) selon la revendication 1, dans lequel la dislocation de plan de base comprend une dislocation s'étendant dans un sens allant de la première zone à la deuxième zone.

3. Cristal de nitrure du groupe 13 (19) selon la revendication 1 ou 2, dans lequel la densité de dislocation de la dislocation de plan de base est supérieure à une densité de joint de grain du plan C.

4. Cristal de nitrure du groupe 13 (19) selon l'une quelconque des revendications 1 à 3, dans lequel la densité de joint de grain d'une section croisant le plan C est supérieure à la densité de joint de grain du plan C.

5. Cristal de nitrure du groupe 13 (19) selon l'une quelconque des revendications 1 à 4, dans lequel le nombre de joints de grain par cm² sur le plan C est égal ou inférieur à 1.

6. Cristal de nitrure du groupe 13 (19) selon l'une quelconque des revendications 1 à 5, dans lequel le premier pic est un pic d'un spectre d'émission apparaissant dans une plage de longueurs d'onde de 364 nm dans une mesure à température ambiante.

7. Cristal de nitrure du groupe 13 (19) selon l'une quelconque des revendications 1 à 6, dans lequel le deuxième pic se situe dans une plage de longueurs d'onde allant de 450 nm à 650 nm dans une mesure à température ambiante.

8. Cristal de nitrure du groupe 13 (19) selon la revendication 7, dans lequel le deuxième pic se situe dans une plage de longueurs d'onde allant de 590 nm à 650 nm dans une mesure à température ambiante.

9. Substrat de cristal de nitrure du groupe 13 (100) comprenant le cristal de nitrure du groupe 13 (19) selon l'une quelconque des revendications 1 à 8.

10. Cristal de nitrure du groupe 13 (19) selon l'une quelconque des revendications 1 à 8, dans lequel la concentration de bore de la troisième zone (29a) est égale ou supérieure à 4x10¹⁸ atm/cm³, et la concentration de bore de la quatrième zone (29b) est inférieure à 4x10¹⁸ atm/cm³.

11. Cristal de nitrure du groupe 13 (19) selon la revendication 10, dans lequel la concentration de bore de la troisième zone (29a) est égale ou supérieure à 6x10¹⁸ atm/cm³, et la concentration de bore de la quatrième zone (29b) est inférieure à 1x10¹⁸ atm/cm³.
